# EUROPEAN PATENT SPECIFICATION

(11) **EP 3 497 068 B1**
(45) Date of publication and mention of the grant of the patent: **19.01.2022**
(21) Application number: 17746501.0
(22) Date of filing: 03.08.2017
(51) Int. Cl.: C03C 23/00, C03C 17/28, C03C 17/30, C08J 3/28, C08F 261/04

(54) **PROCESS FOR MODIFICATION OF A SOLID SURFACE**
VERFAHREN ZUR MODIFIZIERUNG EINER FESTEN OBERFLÄCHE
PROCÉDÉ DE MODIFICATION D'UNE SURFACE SOLIDE

(30) Priority: 08.08.2016 EP 16183185; 13.01.2017 EP 17151368
(43) Date of publication of application: 19.06.2019
(73) Proprietor: Surfix B.V., 6700 AG Wageningen (NL)
(72) Inventor: SCHERES, Luc Maria Wilhelmus, 6700 AG Wageningen (NL); KNOBEN, Wout, 6700 AG Wageningen (NL); MEER, VAN DER, Adriaan Martin Hubert Henri, 6700 AG Wageningen (NL); ZUILHOF, Johannes Teunis, 6700 AG Wageningen (NL); RIJO DA COSTA CARVALHO, Rui Pedro, 6700 AG Wageningen (NL)
(74) Representative: Renkema, Jaap
(86) International application number: PCT/EP2017/069608
(87) International publication number: WO 2018/029065

(56) References cited:
- US-B2- 8 993 479
- NIRMALYA MOITRA ET AL: "Surface Functionalization of Silica by Si-H Activation of Hydrosilanes", JOURNAL OF THE AMERICAN CHEMICAL SOCIETY, vol. 136, no. 33, 20 August 2014 (2014-08-20), pages 11570-11573, XP055224144, US ISSN: 0002-7863, DOI: 10.1021/ja504115d

## Description

The present invention relates to a process for the modification of a surface of a solid material. The present invention further relates to the surface-modified solid material obtainable by such process and its applications.

Surface modification plays an important role in micro- and nanotechnology, as it provides materials and devices with essential properties such as biorecognition, antifouling, and/or (anti)wetting. For many applications it is beneficial to have local control of these properties, i.e. patterns of different functionalities on the surface. Examples include biosensors, microfluidics and substrates for microarrays or cell studies. However, using well-known surface modification technologies such as self-assembled monolayers of (chloro- or alkoxy)silanes or thiols, patterning can only be achieved by complex and time-consuming lithographic processes.

For the preparation of patterned surfaces, a photochemical surface modification method is desirable, as this allows direct constructive patterning by radiating the substrate through a photomask. Several alternative methods for photochemical surface modification are known. For example, light-initiated formation of organic monolayers of alkenes and alkynes on H-terminated (etched) silicon is known from US5429708. Later, it was found that also other etched silicon (and germanium) based materials such as Si₃N₄ and SiC could be modified in a similar way, as described in US8481435 and US8221879. Also, it has been shown in US8993479 that alkenes/alkynes can be photochemically attached to hydroxyl-terminated surfaces (e.g. glass).

Even though these methods are useful for preparing patterned surfaces, there are several drawbacks to the photochemical surface modification by alkene/alkyne monolayers. Most importantly, the preparation of high-quality monolayers is slow (more than 10 hours), thus limiting the practical applicability of the method. Further these modifications should be carried out in the absence of O₂ and H₂O, which reduces the practical application of this method. Moreover, modification of oxide surfaces in the absence of a photoinitiator requires UV radiation at wavelengths of less than 275 nm (typically 254 nm is used), which can cause compatibility issues with biomolecules and substrate materials.

Recently, a two-step surface modification route was reported, allowing light with a longer wavelength (302 nm) to be used for the formation of alkene monolayers on hydrogen-terminated glass (H-glass) (R. Rijo Carvalho, S. P. Pujari, S. C. Lange, R. Sen, E. X. Vrouwe, and H. Zuilhof, "Local Light-Induced Modification of the Inside of Microfluidic Glass Chips", Langmuir 32 (2016) 2389-2398). However, the introduction of Si-H groups at the surface requires an extra step and thus adds complexity. Moreover, the reaction of the alkene is slow and takes 16 h.

Surface modification using hydrosilanes (also referred to as hydridosilanes or silicon hydrides) has been proposed as an alternative to conventional chloro- or alkoxysilane-based methods. Hydrosilanes are more stable in ambient conditions and therefore easier to purify and handle. Moreover, they are compatible with a wider range of terminal functional groups. Hydrosilane layers have been prepared on various metal oxide surfaces, as described in US6331329, US6524655 and US6673459. However, long reaction times at elevated temperature are required to obtain high-quality layers. Moreover, it was found that the metal oxide surface plays a catalytic role and therefore hydrosilanes are found not to react with non-metal surfaces such as SiO₂, carbon black and organic polymers at room temperature (R. Helmy, R.W. Wenslow, and A.Y. Fadeev, "Reaction of Organosilicon Hydrides with Solid Surfaces: An example of Surface-Catalyzed Self-Assembly", J. Am. Chem. Soc. 126 (2004) 7595-7600).

WO2015136913 discloses a method for producing a surface-modified substrate which includes a step for bringing into contact, in the presence of a borane catalyst, a substrate having polar groups present on the surface thereof and a hydrosilane compound having an Si-H group in which a hydrogen atom is bonded to a silicon atom of molecular structure A, and causing a dehydrogenation condensation reaction to advance between the substrate and the compound, thereby forming a substrate having a surface modified by molecular structure A. Using this approach, modification of silica surfaces can be achieved in a few minutes at room temperature. However, since the reaction requires a homogeneous catalyst, surface modification takes place on the whole surface. The method is therefore not suitable for the preparation of patterned layers.

The same authors filed a paper in the J. Am. Chem. Soc 2014, 136, 11570-11573 on the surface modification of silica catalytic activation of Si-H bonds of hydrosilanes.

There is therefore a need for the development of improved photochemical surface modification methods. The improvements may be a reproducible, light-induced reaction with short reaction times. Other improvements may be a large contrast between modified and non-modified surfaces and a good lateral resolution when irradiated locally by means of a photomask.

The invention provides a process for the modification of a surface of a solid material, comprising the step of contacting the surface with a surface-modifying compound under irradiation with light of a wavelength in the range of 200 to 800 nm optionally in the presence of a photoinitiator, wherein
a) the surface has Si-OH groups, C-OH or epoxy groups and the surface-modifying compound is a hydrosilane, or
b) the surface has O-Si-H groups and the surface-modifying compound is a silanol or an alcohol.

It was surprisingly found that a surface modification can be carried out on a variety of different substrate materials. In particular, a surface modification involving a dehydrogenation reaction was found to be possible at room temperature in the absence of a catalyst, by performing the contacting step under irradiation with light. This is particularly surprising in view of the fact that a dehydrogenation reaction was known not to occur between hydrosilanes and non-metal surfaces at room temperature, as described in J. Am. Chem. Soc. 126 (2004) 7595-7600. The process according to the invention further advantageously allows the surface modification to be performed locally and within a short time.

In embodiments a), a photoinitiated dehydrogenation reaction occurs between the hydroxyl groups or epoxy groups of the surface of the solid material and the hydrogen atom bonded to the silicon atom of the hydrosilane.

It is believed that in embodiment a) according to the invention an activation takes place of the Si-H bond of the hydrosilanes close to the surface of the substrate. The activated hydrosilane reacts with the surface of the substrate thereby forming a locally modified surface. This reaction mechanism provides the advantage that reaction times are short, a pattern can be prepared on the substrate and also the sensitivity to moisture and oxygen is reduced.

In embodiments b), a photoinitiated dehydrogenation reaction occurs between the hydrogen atom of the O-Si-H groups of the surface of the solid material and the hydroxyl groups of the silanol or the alcohol.

It is believed that in embodiment b) according to the invention an activation of Si-H bonds on the surface of the substrate occurs, which activated bonds react with Si-OH or C-OH bonds of the silanol or alcohol.

Embodiment a) is a preferred embodiment, since the reaction times are faster compared to embodiment b) and also relative to the prior art, where activation of the surface of the substrate takes place.

In the process of WO2015136913, a homogeneous catalyst is required and surface modification takes place on the whole surface. Unlike the process of WO2015136913, the process according to the invention is catalyst free and allows a spatially selective surface modification by use of a mask, for example a photomask. Accordingly, in some preferred embodiments of the process of the invention, a predetermined part of the surface is selectively subjected to the irradiation. Preferably, a photomask or a mask that may be in direct contact with the solid material selectively blocks a predetermined part of the surface from being irradiated, resulting in selective modification of that part of the surface that is not blocked by the mask, i.e. patterning of the surface.

The ability to perform a photochemical surface modification according to the present invention enables the patterning of said surface. In a further preferred embodiment, the process according to the invention is applied for the selective modification, with a predetermined pattern, of the surface of spatially confined microchannels on or below the surface of a solid material. Thus in one embodiment the modified surface is the surface of spatially confined microchannels, on and/or under the outer surface of the solid material.

The contacting of the solid material and the surface-modifying compound is carried out under irradiation with light of a wavelength in the range of 200 to 800 nm. This may be carried out in the presence of a photoinitiator or in the absence of a photonitiator. The presence of a photoinitiator is suitable for initiating or accelerating the reaction when necessary. For example, when the light has a wavelength in the range of 300 to 800 nm, the irradiation is preferably carried out in the presence of a photoinitiator.

In some preferred embodiments of the invention, the irradiation is carried out in the absence of a photoinitiator and the light has a wavelength in the range of 260 nm to 300 nm, more preferably 280 nm to 300 nm. This advantageously avoids compatibility issues with biomolecules and substrate materials.

In some preferred embodiments of the invention, the irradiation is carried out in the presence of a photoinitiator and under irradiation with light of a wavelength in the range of 300 to 800 nm, preferably with a wavelength lower than 700 nm, or lower than 600 nm, or lower than 500 nm, or lower than 400 nm, more preferably lower than 380 nm, even more preferably lower than 350 nm and in particular lower than 330 nm.

Depending on the type of the surface-modifying compound and the surface, desirable results may also be obtained by irradiation with light having a wavelength in the range of 300 to 800 nm in the absence of a photoinitiator.

Examples of suitable photoinitiators include, but are not limited to alkyl bromides, benzyl iodides, 2,2-dimethoxy-2-phenyl acetophenone, benzophenone and the like. The amount of photoinitiator present in the reaction mixture may be in the range of 0.01 to 5.0 wt. %, more preferably in the range of 0.01 to 3 wt. %, even more preferably in the range of 0.01 to 2 wt. %, and in particular in the range of 0.01 to 1 wt %, relative to the surface-modifying compound.

The process according to the present invention is applicable to various types of solid materials. A solid material is defined as a material that is in the solid state at ambient temperature, e.g. 20° C.

The process according to the present invention may be applied on various different types of surfaces, both planar and curved, and examples comprise particles (e.g. micro- or nanoparticles), powders, crystals, films or foils.

### embodiments a)

In some preferred embodiments, the surface has Si-OH groups or C-OH groups and the surface-modifying compound is a hydrosilane.

### solid material

The solid material may have a surface having Si-OH groups, C-OH groups or epoxy groups. Preferably the solid material contains Si-OH or C-OH groups.

Examples of suitable solid materials having a surface having Si-OH groups include for example silica and glass (such as synthetic fused silica and borosilicate glass), oxidized silicon, oxidized silicon nitride, oxidized silicon carbide and plastics and polymers provided on the surface with a film of silica, glass, oxidized silicon, oxidized silicon nitride or oxidized silicon carbide.

Examples of suitable solid materials having a surface having C-OH groups include etched silicon carbide and natural polymers such as polysaccharides (e.g. (nitro)cellulose) and paper and synthetic polymers such as poly(vinyl alcohol). An example of silicon carbide having C-OH terminated surfaces prepared by etching with HF is described in Langmuir 2013, 29, 4019-4031.

Examples of suitable solid materials having a surface having epoxy groups, include solid materials that have been treated with an epoxy silane compound, and epoxy polymers like for example negative photoresist SU-8.

Solid materials having a surface having C-OH groups may also be created by oxidation, e.g. by exposure to O₂ plasma or the application of a piranha solution (mixture of sulfuric acid and hydrogen peroxide) to diamond, graphite, graphene, or plastics and organic polymers not having C-OH groups in their native state, such as polyethene and cyclic olefin copolymers.

### pretreatment of surface

Preferably, the solid material is subjected to a pretreatment step prior to the irradiation step, in order to increase the number of hydroxyl groups and/or activate the hydroxyl groups on the surface of the solid material. Optionally, the pretreatment step comprises contacting the surface with a mixture comprising an acid and optionally an organic solvent. Several methods for the cleaning and/or activation of glass surfaces are described in the literature, such as Cras, J. J., Rowe-Taitt, C. A., Nivens, D. A., and Ligler, F. S., Biosensors & Bioelectronics 14, 683-688 (1999). The pretreatment step according to the present invention may, for example, comprise immersing the surface having Si-OH groups in a 1:1 (v:v) mixture of hydrochloric acid and methanol for 30 minutes or more, followed by washing with water and methanol and drying. Another well-known method is the application of a piranha solution (mixture of sulfuric acid and hydrogen peroxide).

In some embodiments, the process comprises the step of treating the surface to have micro- and/or nanoscale surface roughness before the irradiation step. This can be realized in many ways, e.g. casting (nano)particle solutions, sol-gel processes, and chemical vapour deposition (CVD) to prepare roughness in the order of micro- and nanometers on the surface.

By introducing a certain degree of roughness to an already hydrophilic surface, the surface may become superhydrophilic, i.e. the surface has a water contact angle of less than 10°, more preferably less than 5°. If such a superhydrophilic surface is treated with a hydrophobic surface-modifying compound in the irradiation step according to the invention, the irradiated surface may become superhydrophobic, i.e. the irradiated surface has a water contact angle of more than 140°, more preferably more than 150°. Thus, a very large wettability contrast can be obtained between irradiated and non-irradiated surfaces.

The step of introducing micro- and/or nanoscale surface roughness may also improve other surface properties, like increased immobilisation of biomolecules and improved antifouling properties, by increasing the amount of surface-bound molecules.

### hvdrosilane

The hydrosilane may be represented by 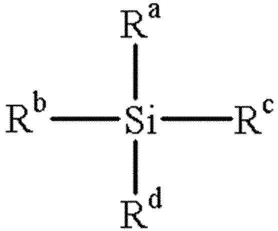
where at least one of R^{a}, R^{b}, R^{c}, and R^{d} is H and at least one of R^{a}, R^{b}, R^{c}, and R^{d} is not H,
where each of R^{a}, R^{b}, R^{c}, and R^{d} is, independently, H, linear C₁₋₃₀ alkyl, branched C₁₋₃₀ alkyl, cyclic C₃₋₃₀ alkyl, linear C₂₋₃₀ alkenyl, branched C₂₋₃₀ alkenyl, linear C₂₋₃₀ alkynyl, branched C₂₋₃₀ alkynyl, C₆₋₂₀ aralkyl, C₆₋₁₀ aryl, or a polymeric moiety having a molecular weight of about 1000 to about 100,000. The polymeric moiety is selected from the group consisting of hydrocarbon polymers, polyesters, polyamides, polyethers, polyacrylates, polyurethanes, epoxides, polymethacrylates and polysiloxanes (e.g. poly(methylhydrosiloxane)). Each of R^{a}, R^{b}, R^{c}, and R^{d} is optionally substituted with one or more substituents selected from the group consisting of -F, -Cl, -Br, -CN, -NO₂, =O, -N=C=O, -N=C=S, 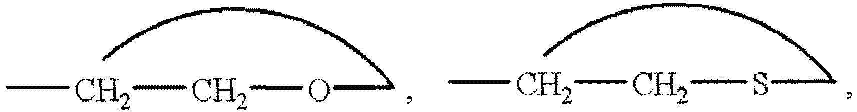 -N₃, -NR^{e}R^{f}, -SR^{g}, -OR^{h}, -CO₂Rⁱ, -PR^{j}R^{k}R^{l}, -P(OR^{m}) (ORⁿ) (OR^{p}), -P(=O) (OR^{q}) (OR⁸), -P (=O)₂OR^{t}, -OP(=O)₂OR^{u}, -S(=O)₂R^{v}, -S(=O)R^{w}, -S(=O)₂OR^{x}, -C(=O)NR^{y}R^{z}, and -OSiR^{aa}R^{bb}R^{cc}. Each of R^{e}, R^{f}, R^{g}, R^{h}, Rⁱ, R^{j}, R^{k}, R^{l}, R^{m}, Rⁿ, R^{p}, R^{q}, R^{s}, R^{t}, R^{u}, R^{v}, R^{w}, R^{x}, R^{y}, and R^{z}, is, independently, H, linear C₁₋₁₀ alkyl, branched C₁₋₁₀alkyl, cyclic C₃₋₈ alkyl, linear C₂₋₁₀ alkenyl, branched C₂₋₁₀ alkenyl, linear C₂₋₁₀ alkynyl, branched C₂₋₁₀ alkynyl, C₆₋₁₂aralkyl, or C₆₋₁₀ aryl, and is optionally substituted with one or more substituents selected from the group consisting of -F, -Cl, and -Br. Each of R^{aa},R^{bb}, and R^{cc} is, independently, linear C₁₋₁₀ alkyl, branched C₁₋₁₀ alkyl, cyclic C₃₋₈ alkyl, linear C₂₋₁₀ alkenyl, branched C₂₋₁₀ alkenyl, linear C₂₋₁₀, alkynyl, branched C₂₋₁₀ alkynyl, C₆₋₁₂ aralkyl, C₆₋₁₀ aryl, -F, -Cl, -Br, or OR^{dd}, where R^{dd} is linear C₁₋₁₀ alkyl or branched C₁₋₁₀ alkyl.

Preferred examples of the hydrosilanes include compounds represented by 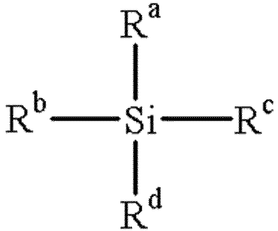 where at least one of R^{a}, R^{b}, R^{c}, and R^{d} is H, at least one (preferably one) of R^{a}, R^{b}, R^{c}, and R^{d} is a group represented by the formula selected from the following list A and the remaining R^{a}, R^{b}, R^{c}, and R^{d} is independently chosen from the groups as described above (e.g. C₁-C₃₀ alkyl), wherein the list A consists of:

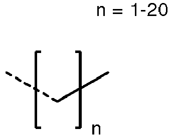

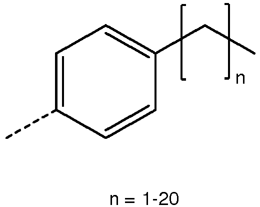

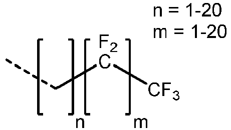

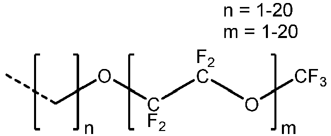

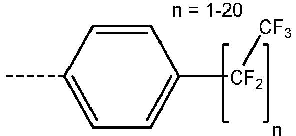

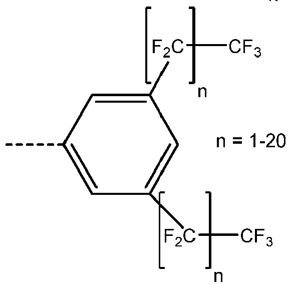

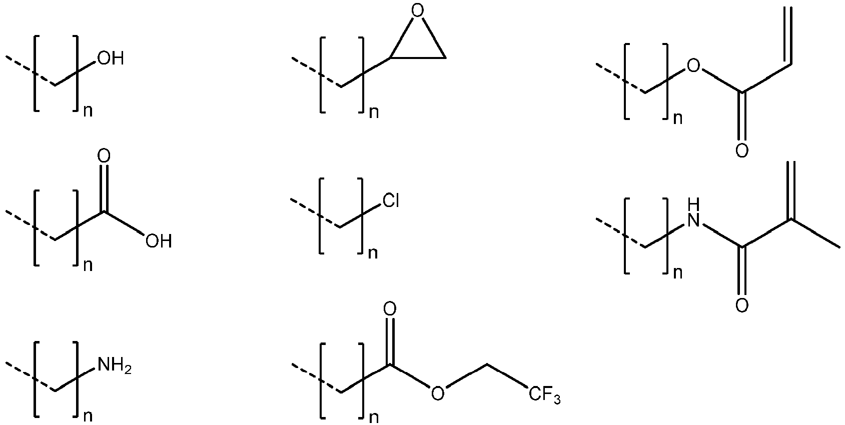

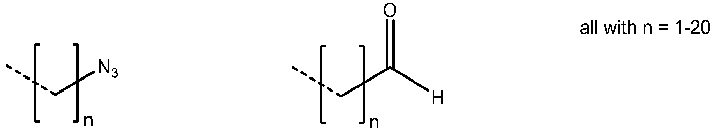

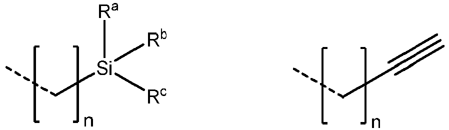

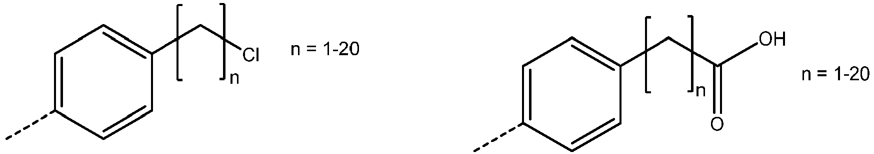

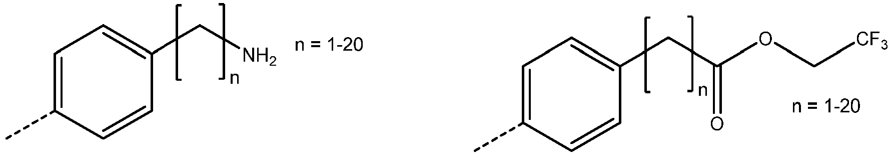

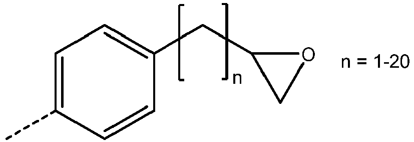

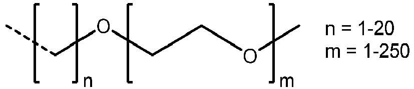

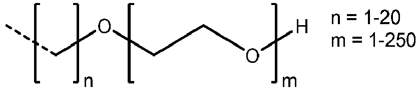

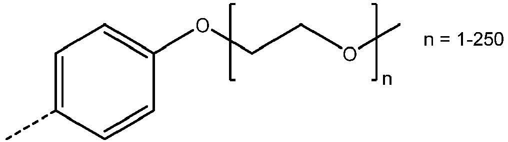

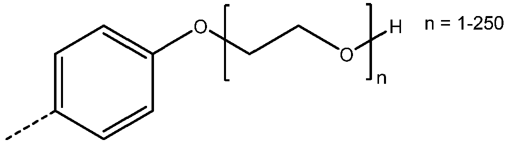

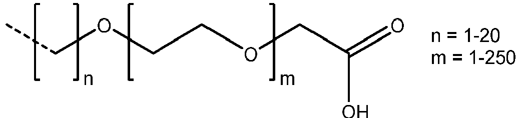

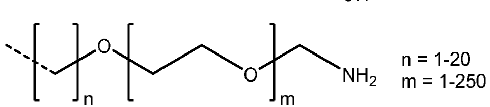

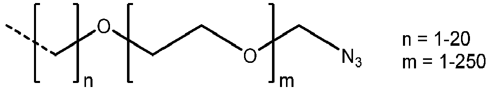

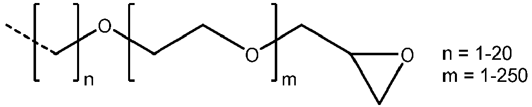

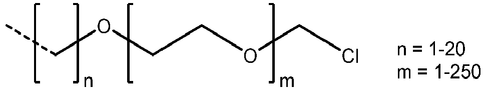

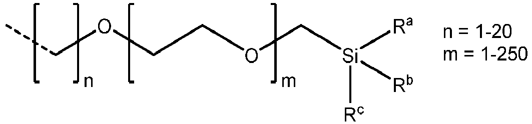

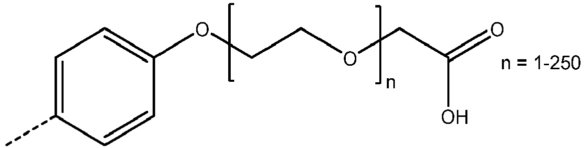

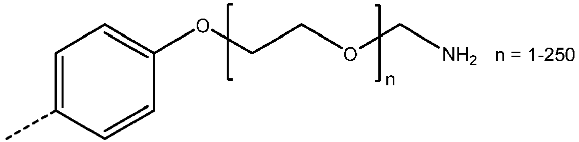

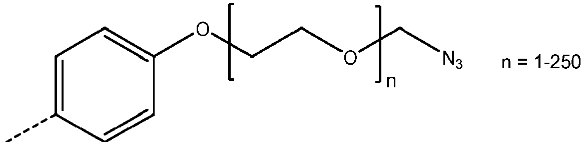

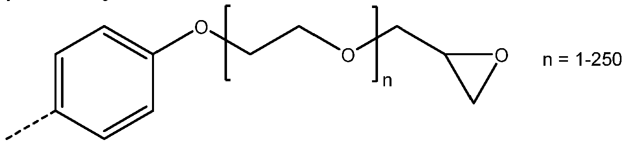

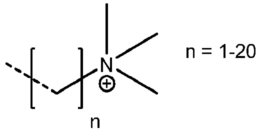

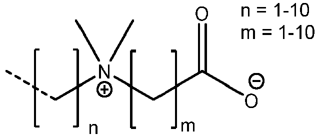

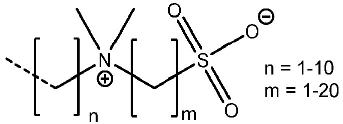

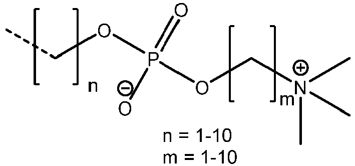

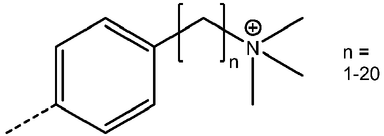

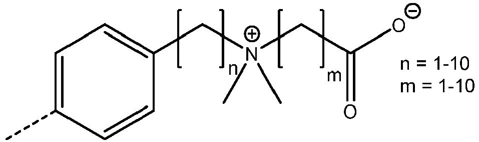

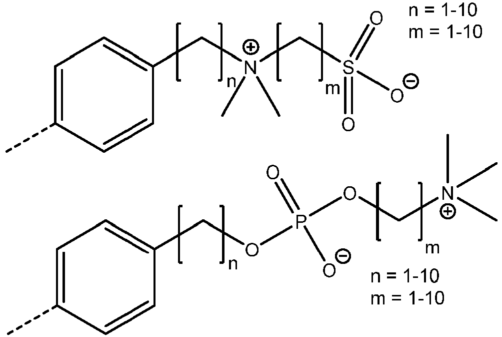

For the avoidance of doubt, it is noted that these groups are bonded to another element by the dashed line (---). Accordingly, for example, the group 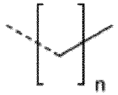 is bonded to Si as Si-CH₂CH₃ when n is 1 and Si-(CH₂)₅CH₃ when n is 5.

An example of the suitable hydrosilane is octakis(hydridodimethylsiloxy)octasilsesquioxane.

The number of H in the hydrosilane determines the time required for the reaction to be completed and the selectivity of the reaction to the irradiated area (contrast and resolution). Regarding the selectivity, the two important parameters for the patterned surfaces according to the invention are
1) (chemical) contrast - (maximum) difference in effectiveness of the surface modification reaction. For a hydrophobicity-inducing surface modification this is e.g. measured by the difference in water contact angle (WCA) between the irradiated and non-irradiated areas.
2) (lateral) resolution - distance over which the effectiveness of the surface modification changes from maximum to minimum value, i.e. 'sharpness' of the interface between irradiated and non-irradiated areas.

The higher number of H in the hydridosilane leads to a shorter reaction time. The number of H in the hydrosilane influences the (chemical) contrast.

In some embodiments, one of R^{a}, R^{b}, R^{c}, and R^{d} is H. This is suitable when less dense surface modification layer and good contrast are of primary importance, while the reaction time may be longer than where other hydrosilanes are used. The irradiation may be performed e.g. for 60-75 minutes.

In some embodiments, two of R^{a}, R^{b}, R^{c}, and R^{d} are H. This is suitable when a good balance of a short reaction time and a good contrast is of primary importance. The irradiation may be performed e.g. for 10-15 minutes.

In some embodiments, three of R^{a}, R^{b}, R^{c}, and R^{d} are H. This is suitable when a short reaction time is of primary importance. The higher intrinsic reactivity may cause also some undesired reaction in the non-irradiated areas and hence the contrast may be lower than where e.g. dihydrosilanes are used. The irradiation may be performed e.g. for 1-10 minutes.

### embodiments b)

In some preferred embodiments, the surface has O-Si-H groups and the surface-modifying compound is a silanol or an alcohol.

The solid material may e.g. be a glass, plastic or polymer modified to have a surface having O-Si-H groups. Such surface may be obtained e.g. by reacting a hydroxyl-terminated surface such as glass or oxidized plastic or polymer with an alkoxysilane having one, two or three Si-H groups, for example (EtO)₃SiH, (EtO)₂SiH₂ or (EtO)SiH_{3.}An example of this using triethoxysilane (EtO)₃Si-H is described in R. Rijo Carvalho, S. P. Pujari, S. C. Lange, R. Sen, E. X. Vrouwe, and H. Zuilhof, "Local Light-Induced Modification of the Inside of Microfluidic Glass Chips," Langmuir 32 (2016) 2389-2398.

Preferably, the solid material is hydrogen-terminated glass (H-glass) or poly(methylhydrosiloxane).

The surface-modifying compound may be represented by

HO-Si-R¹R²R³

wherein each of R¹, R² and R³ is independently chosen from the groups as described for R^{a}, R^{b}, R^{c}, and R^{d}.

Preferably, at least one (preferably one) of R¹, R², R³ is a group selected from the list A described with respect to the hydrosilanes

The surface-modifying compound may be represented by

HO-C-R⁴R⁵R⁶,

wherein each of R⁴, R⁵ and R⁶ is, independently chosen from the groups as described for R^{a}, R^{b}, R^{c}, and R^{d}.

Preferably, at least one (preferably one) of R⁴, R⁵, R⁶ is a group selected from the list A described with respect to the hydrosilanes

### surface-modifying compound composition

The surface-modifying compound may be contacted with the surface without prior mixing with another component or in the form of a surface-modifying compound composition comprising the surface-modifying compound and one or more other components. If the surface-modifying compound is contacted with the surface in the form of a hydrosilane composition, the amount of the surface-modifying compound in the surface-modifying compound composition may be selected within a broad range, for example 0.1-99.9 vol%, 1-99 vol%, 10-90 vol%, 25-75 vol% or 40-60 vol%, of the hydrosilane composition. The surface-modifying compound may be the major component of the surface-modifying compound composition, e.g. the amount of the surface-modifying compound in the surface-modifying compound composition may be at least 50 vol% and less than 100 vol%, for example 50-99.9 vol%, for example 60-95 vol% or 70-90 vol%, of the surface-modifying compound composition. It is also possible that the surface-modifying compound is not the major component of the surface-modifying compound composition, e.g. the amount of the surface-modifying compound in the surface-modifying compound composition is less than 50 vol% and more than 0 vol%, for example 0.1-49.9 vol%, for example 5-40 vol% or 10-30 vol%, of the surface-modifying compound composition.

The amount of the hydrosilane or the hydrosilane composition to be used in the process according to the invention is selected to be sufficient to cover the surface to be irradiated.

The process according to the invention results in the formation of a surface modification layer on the surface of the solid material. The surface modification layer may have a thickness in the range of 0.1 nm to 100 µm, for example 1 nm to 10 µm or 10 nm to 1 µm.

The surface-modifying compound composition may comprise a photoinitiator as described above. The amount of the photoinitiator in the composition may be in the range of 0.01 to 5.0 wt. %, more preferably in the range of 0.01 to 3 wt. %, even more preferably in the range of 0.01 to 2 wt. %, and in particular in the range of 0.01 to 1 wt %, relative to the surface-modifying compound.

The surface-modifying compound composition may comprise a suitable inert solvent. In this case, the amount of the solvent in the surface-modifying compound composition may be selected within a broad range, for example 0.5-99.5 vol%, 10-90 vol% or 25-75 vol%, of the surface-modifying compound composition.

The surface-modifying compound composition may comprise a compound that is reactive towards the surface-modifying compound. In this case, the amount of such compound may be selected within a broad range, for example 0.5-99.5 vol%, 10-90 vol% or 25-75 vol%, of the surface-modifying compound composition. The addition of such a compound during the irradiation may speed up the reaction and/or limit the reaction to occur inside of the irradiated area. This is particularly advantageous in increasing the contrast and the resolution. The addition of such a compound during irradiation may also increase the thickness of the surface modification layer and/or may influence the porosity of the surface modification layer. In embodiments a), the compound reactive towards the surface-modifying compound may e.g. be an alcohol, thiol, alkene, alkyne, (meth)acrylate, epoxy or (meth)acrylamide, preferably having a group selected from the list A described with respect to the hydrosilanes. In embodiments b), the compound reactive towards the surface-modifying compound may e.g. be a hydrosilane or thiol, preferably having a group selected from the list A described with respect to the hydrosilanes.

In some embodiments, the amount of the compound that is reactive towards the surface-modifying compound in the surface-modifying compound composition is 50-99.9 vol%, for example 60-95 vol% or 70-90 vol%, of the surface-modifying compound composition. In this case, the surface modification according to the invention results in the formation of a surface modification layer having functionalities greatly influenced by the functionality of the compound reactive towards the surface-modifying compound. The compound reactive towards the the surface-modifying compound may have an end-group/functionality which may be similar to or different from that of the hydrosilane. In these embodiments, the surface modification layer may have a thickness in the range of 1 nm to 100 µm.

The surface-modifying compound composition may comprise microparticles and/or nanoparticles. Preferably, the microparticles and nanoparticles have a number average diameter of 0.1 nm to 10 µm, 1 nm to 1 µm or 10 nm to 100 nm, as determined according to SEM. In embodiments a) wherein the surface has Si-OH groups, the particles have Si-OH termination or are coated with compounds reactive towards the surface-modifying compound. In embodiments a) wherein the surface has C-OH groups, the particles have Si-OH or C-OH termination or are coated with compounds reactive towards the surface-modifying compound. In embodiments b), the particles have O-Si-H termination or are coated with compounds reactive towards the surface-modifying compound. The amount of such particles may be selected within a broad range, for example 0.1-99.9 wt.%, 10-90 wt.% or 25-75 wt.%, of the surface-modifying compound composition.

Accordingly, the surface-modifying compound may be contacted with the surface in the form of a surface-modifying compound composition comprising the surface-modifying compound and one or more of a photoinitiator, a suitable inert solvent, a compound that is reactive towards the surface-modifying compound and microparticles and/or nanoparticles. In particularly preferred embodiments, the process involves a) and the surface-modifying compound composition comprises a compound that is reactive towards the hydrosilane.

The present invention further provides the surface-modified solid material obtained by or obtainable by the process of the invention.

The present invention further provides an article comprising the surface-modified solid material according to the invention. Optionally, the article has micro- or nanostructures.

Preferred examples of the article according to the invention include a substrate for biochip applications such as microarray applications and cell culture applications; a microfluidic device such as a lab-on-a-chip device or an organ-on-a-chip device.

It is noted that the invention relates to all possible combinations of features described herein, preferred in particular are those combinations of features that are present in the claims. It will therefore be appreciated that all combinations of features relating to the composition according to the invention; all combinations of features relating to the process according to the invention and all combinations of features relating to the composition according to the invention and features relating to the process according to the invention are described herein.

It is further noted that the term 'comprising' does not exclude the presence of other elements. However, it is also to be understood that a description on a product/composition comprising certain components also discloses a product/composition consisting of these components. The product/composition consisting of these components may be advantageous in that it offers a simpler, more economical process for the preparation of the product/composition. Similarly, it is also to be understood that a description on a process comprising certain steps also discloses a process consisting of these steps. The process consisting of these steps may be advantageous in that it offers a simpler, more economical process.

When values are mentioned for a lower limit and an upper limit for a parameter, ranges made by the combinations of the values of the lower limit and the values of the upper limit are also understood to be disclosed.
Figure 1 shows photochemical surface modification with different concentrations of dihydro-F17, showing the difference in WCA between the irradiated (squares) and non-irradiated (circles) part of the sample.
Figure 2 shows photochemical surface modification with different concentrations of trihydro-F17, showing the difference in WCA between the irradiated (squares) and non-irradiated (circles) part of the sample.
Figure 3 shows irradiation spectra used for photochemical surface modification without (black line) and with (gray line) the presence of an additional glass filter. The dotted line indicates the transmission spectrum of the glass filter.

The invention is now elucidated by way of the following examples, without however being limited thereto.

### Examples

### General

### Materials

Commercially available hydrosilanes and solvents were obtained from Sigma-Aldrich or Gelest. When needed, compounds were purified using Kugelrohr vacuum distillation. Hydrosilanes that are not commercially available were synthesized by reduction of the corresponding chlorosilanes with LiAlH₄ using a procedure adapted from literature.

### Surface modification

The sample was placed on a custom-made sample holder and a volume of hydrosilane (neat or as a surface-modifying compound composition) was deposited on the surface. Then, the sample was covered by a quartz cover, resulting in a uniform liquid film between the sample and the mask.

Next, the sample was irradiated with UV light at an intensity of 10-15 mW/cm², using a collimated light source. After completion of the reaction samples were rinsed with a suitable solvent, followed by rinsing and ultrasonication with dichloromethane. Finally, samples were dried in a stream of Ar.

### Surface characterization

Samples were analyzed by static water contact angle (WCA) measurements using a Krüss DSA-100 goniometer. Using the automated dispensing unit, 3 µL water droplets were deposited on the surface, images were captured using a digital camera and analyzed using a suitable fitting algorithm, depending on the wettability of the surface.

XPS spectra were recorded on a JPS-9200 apparatus (JEOL). Measurements were done using a monochromatic Al Kα source operated at 12 kV and 20 mA . All binding energies were calibrated relative to the hydrocarbon (CH₂) peak, which was set to a binding energy of 285.0 eV. Charge compensation was used to prevent electrostatic charging of the substrate during measurement. Spectra were analyzed with Casa XPS software.

Fluorescence microscopy was used to demonstrate the formation of micro-patterned surfaces. Droplets of a 1 mg/ml solution of a fluorescently labelled protein (BSA labelled with AlexaFluor 488, Thermo Fisher) were deposited on the patterned substrate and incubated for 15 min. at room temperature. Unbound protein was removed from the surface by rinsing with water and washing with PBS (pH 7.4) containing 0.05% (v/v) of Tween 20, PBS (pH 7.4) and once more with water (5 min. immersion on a shaker in each washing solution). Samples were analyzed using a fluorescence microscope.

### 1 Surface modification of glass with fluorinated hydrosilanes

### Sample preparation

Standard glass microscope slides were cleaned by ultrasonication in acetone, followed by exposure to a low-pressure O₂ plasma and immersion in piranha solution. After thorough rinsing with deionized water, samples were dried using a stream of Ar.

Following fluorinated hydrosilanes were used.

**Table 1**

| Name | Abbreviation |
|---|---|
| (heptadecafluoro-1 ,1 ,2,2-tetra hydro-decyl)dimethylhydrosilane | monohydro-F17 |
| (heptadecafluoro-1 ,1 ,2,2-tetra hydro-decyl)methylhydrosilane | dihydro-F17 |
| (heptadecafluoro-1,1,2,2-tetra hydro-decyl)trimethylhydrosilane | trihydro-F17 |
| (heptadecafluoro-1 ,1 ,2,2-tetra hydro-decyl)di-isopropylhydrosilane | isopropyl-F17 |

### Surface modification

To demonstrate the principle of photochemical surface modification using hydrosilanes, a very simple photomask was used with which half of the substrate is irradiated, and the other half is not. By using hydrosilanes with a hydrophobic fluorinated 'tail', successful surface modification will result in a large wettability contrast between the modified (irradiated) and unmodified (non-irradiated) parts of the substrate, which can easily be demonstrated by water contact angle (WCA) measurements.

To investigate the effect of the number of Si-H bonds in the hydrosilane, molecules with one, two and three Si-H bonds were used. These are abbreviated as monohydro-F17, dihydro-F17 and trihydro-F17, respectively. The names of these hydrosilanes are given in Table 1. Fluorinert^{™} FC-70 was used as the solvent, and surface modifications at different hydrosilane concentrations (given as % (v/v)) and irradiation times were compared.

### 1.1 Results - number of Si-H bonds

After cleaning and activation, glass slides are strongly hydrophilic with a water contact angle (WCA) of less than 20°.

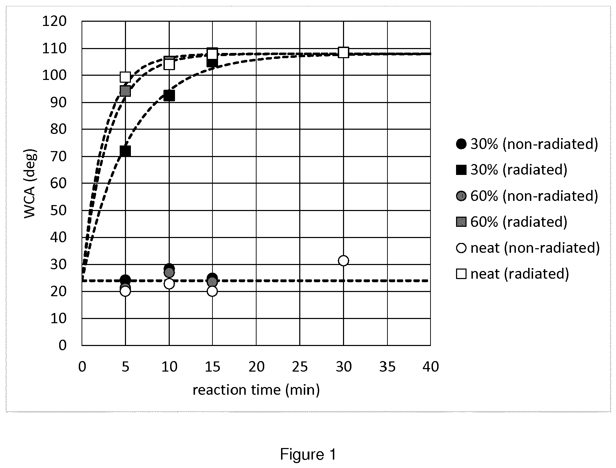

Figure 1 shows the change in WCA upon reaction with dihydro-F17. In the non-radiated part of the sample, no reaction takes place and the WCA stays very close to its original value. In the irradiated part on the other hand, a strong increase in WCA is observed, finally reaching a value of 108±1 °.

For the neat hydrosilane and the 60% solution, the maximum WCA is reached within 15 minutes. At a concentration of 30% the reaction takes longer to complete, but the same WCA is reached eventually.

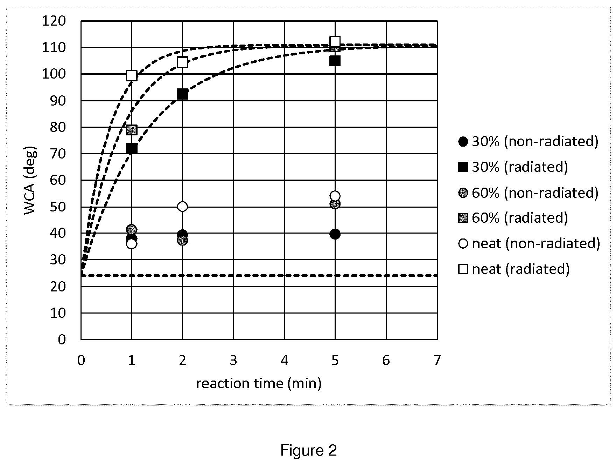

Figure 2 shows the change in WCA upon reaction with trihydro-F17. Formation of a trihydro-F17 layer takes much less time, as shown in Figure 2. For the neat trihydro-F17 and the 60% solution, the layer is complete within 5 minutes. Also, the maximum WCA of 111±2° is somewhat higher than for dihydro-F17.

However, there is also an increase in WCA in the non-radiated part of the sample. Thus, simultaneous to the photochemical surface modification, some unwanted reaction takes place, making it less suitable for the patterning of a solid material when the solid material is glass.

Surface modifications were also carried out using a 30% solution of monohydro-F17. For this hydrosilane, a maximum WCA of 101±3°was reached after 75 minutes of irradiation. In the non-radiated area, a WCA of 28±3° was measured.

Hence, the reaction speed was the highest with trihydro-F17, then dihydro-F17 and then monohydro-F17. The contrast was the best with dihydro-F17.

XPS analysis also confirmed the results of the WCA measurements in that much larger amounts of elements F and C were found in the irradiated areas, as shown in Table 2.

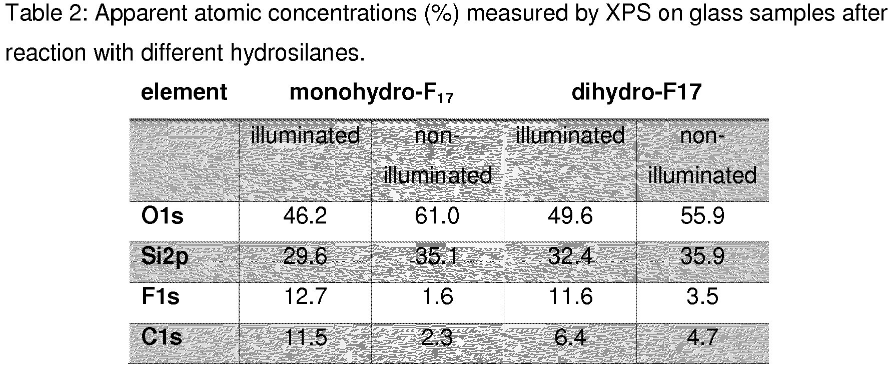

### 1.2 Results - effect of organic substituent

In the experiments described above the number of Si-H bonds and methyl substituents was varied. To investigate the role of the organic group, a surface modification was done using a fluorinated monohydrosilane with two isopropyl substituents (isopropyl-F17, cf. Table 1). For this molecule, the same surface modification procedure as for the methyl-substituted monohydro-F17 was used (30% hydrosilane solution, 75 min. irradiation). The resulting WCAs are 32° and 108° in the non-radiated and irradiated area, respectively. This result shows that the photochemical surface modification reaction is not limited to hydrosilanes with methyl substituents and that other substituents, including more bulky ones, may also be used.

### 1.3 Results - preparation of micropatterned surfaces

To investigate the lateral resolution of the photochemical hydrosilane surface modification, a different photomask was used, consisting of a pattern of lines of varying width. After photochemical surface modification with dihydro-F17 (neat, 15 min. irradiation), this should yield fluorinated lines with a width between 1 and 500 µm. The spacing between the lines is twice the width of the line.

These patterns are too small to perform routine WCA measurements. To confirm and visualize pattern formation, samples were incubated with fluorescently labelled BSA, which is known to adsorb differently to hydrophobic (e.g. fluorinated) and hydrophilic (e.g. glass) surfaces. Fluorescence microscopy clearly showed that there is a difference in fluorescence intensity between the fluorinated lines and the non-fluorinated background. Similar experiments were done with monohydro-F17 (30% solution, 75 min. irradiation), this time using a pattern of 5 m circular dots and using both the positive and negative pattern. Also here, there was a clear difference in fluorescence intensity between the fluorinated and non-fluorinated areas on the sample. These results demonstrate that photochemical surface modification by hydrosilane layers can be used for the preparation of micro patterned surfaces with feature sizes down to at least 5 m.

### 1.4 Results - preparation of superhydrophobic/superhydrophilic patterns

In the experiments described above it has been demonstrated that (micro)patterns with a large wettability contrast can be prepared using photochemical surface modification by hydrosilanes. The wettability contrast can be increased further by introducing roughness to the surface. One way to achieve this is the growth of so-called silicone nanofilaments (SiNF).

Based on a literature procedure, SiNF were prepared from methyltrichlorosilane, using a gas-phase procedure and subsequently oxidized using a low-pressure O₂ plasma to render the surface with hydroxyl groups and leading to a superhydrophilic SiNF layer on the surface (WCA <10°).

These substrates were used for photochemical surface modification using trihydro-F17 (30% solution, 8 min. irradiation). On the non-irradiated area, the substrate remains superhydrophilic (WCA <10°). On the irradiated area, reaction with the fluorinated hydrosilane renders the surface superhydrophobic (static WCA >150 °C, sliding angle <10°). Thus, photochemical surface modification by hydrosilanes can be used to prepare patterns of superhydrophobic and superhydrophilic areas.

### 1.5 Results - photoactivation of hydrosilanes

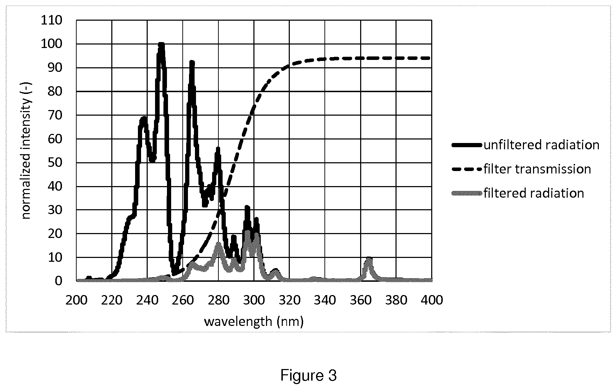

The collimated light source used in the experiments uses a Hg/Xe lamp in combination with a 260 mirror set. In the resulting irradiation spectrum (the light that is actually illuminating the sample surface), three groups of peaks can be distinguished: 220-255 nm, 255-290 nm and 290-320 nm, see Figure 3.

To investigate which parts of the spectrum are needed for the photochemical surface modification, an additional filter was used to prevent part of the light from reaching the sample. For this purpose a piece of glass was used which completely blocks the light in the 220-255 nm wavelength range and most of the 255-290 nm range. Figure 3 shows the transmission spectrum of the glass filter and the resulting filtered irradiation spectrum.

With the glass filter in place, a standard surface modification was done with dihydro-F17 (neat, 15 min. irradiation). The resulting WCA are 29° and 105° for the non-radiated and irradiated area, respectively. These values are almost identical to those obtained without the glass filter. Thus, it can be concluded that the reaction does not necessarily require light in the 220-255 nm range. Considering the large intensity difference between the filtered and unfiltered irradiation spectra in the 255-290 nm range (see Figure 3), a lower quality layer would have been expected if light in this wavelength range would be essential for the reaction to proceed. Therefore, these results indicate that the photochemical surface modification reaction by hydrosilanes can effectively be initiated by light in the wavelength range 290-320 nm, where the effect of the glass filter is small to marginal.

The fact that the presence of a glass filter does not significantly affect the surface modification not only provides information about the required wavelength. It also demonstrates that photochemical surface modification using hydrosilanes can also be performed inside a channel with a glass cover. This is highly relevant for applications in microfluidics.

### 1.6 Results - addition of acrylate

It was found that both the wettability contrast and the lateral resolution of the patterns can be improved by the addition of 1H,1H,2H,2H-perfluorodecyl acrylate (F17-acrylate) to the hydrosilane. Photochemical surface modification was done using dihydro-F17 containing F17-acrylate in concentrations varying between 0.1 and 99.9% (v/v) and irradiation times between 1 and 30 minutes.

Good results were obtained using F17-acrylate concentrations below or equal to 1% and an irradiation time of 15 minutes. In this case, WCA of 20° and 114±1° are obtained in the non-radiated and irradiated area, respectively. Thus, the wettability contrast is improved compared to the experiment without F17-acrylate, where WCA of 20° and 108±1° were obtained in the non-radiated and irradiated area, respectively (as shown in Figure 1). Moreover, the interface between the hydrophobic (radiated) and hydrophilic (non-radiated) areas of the sample is sharper when F17-acrylate is added. This improvement in the lateral resolution is visualized by allowing water vapor to condense on the samples. The difference in wettability between irradiated and non-radiated areas results in condensation patterns. On samples with F17-acrylate, significantly sharper lines between hydrophobic and hydrophilic areas are observed.

Even though good results are obtained using a low concentration of F17-acrylate, surface modification can also be done using much higher concentrations. For example, an experiment using 99% F17-acrylate and 1% dihydro-F17 yielded WCA of 31±2° and 116±2° in the non-irradiated and irradiated area, respectively.

As control experiments, two reactions were done using 1) a solution of 1% F17-acrylate in FC-70 and 2) using the F17-acrylate neat, i.e. both without any hydrosilane. In both cases, hardly any change in wettability is observed (1% F17-acrylate in FC-70 yielding WCA 20° in both irradiated and non-radiated area, and neat F17-acrylate yielding WCA 42±5° ° and 29±2° in irradiated and non-radiated area, respectively), indicating that no significant surface modification takes place. These results demonstrate that the hydrosilane is required for surface modification, and the observed wettability contrast of the patterns is not caused by surface binding of F17-acrylate alone.

### 1.7 Results - surface modification using longer wavelengths in the presence of a photoinitiator

As shown above, photochemical surface modification using hydrosilanes takes place under irradiation with light in the wavelength range 200-320 nm. To investigate the effect of longer wavelengths, surface modifications were done using a 365 nm UV-A lamp. In an experiment using dihydro-F17 containing 1% F17-acrylate and an irradiation time of 15 minutes, WCA of 35±1° and 38±3° were obtained in the non-radiated and irradiated area, respectively. This result shows that no significant surface modification takes place at this wavelength.

In a next experiment, 1% of a photoinitiator (2,2-dimethoxy-2-phenylacetophenone, DMPA) was added to the dihydro-F17/F17-acrylate mixture. Again an irradiation time of 15 minutes was used. To reduce the effect of ambient light, the experiment was done in a dark room. The reaction with DMPA yielded WCA of 76° and 105° in the non-irradiated and irradiated area, respectively. The wettability contrast between the irradiated and non-irradiated area is smaller than in experiments where wavelengths below 320 nm were used for irradiation (without photoinitiator). However, there is still a clear difference in WCA between the irradiated and non-radiated area, indicating that light with a wavelength above 320 nm can be used for photochemical surface modification using hydrosilanes provided a suitable photoinitiator is present.

### 2 Results - Surface modification of C-OH surfaces with hydrosilanes

### 2.1 Cyclic Olefin Copolymer

### Sample preparation

Pieces of Cyclic Olefin Copolymer (COC) were activated by exposure to a low-pressure O₂ plasma. This results in a strong decrease of WCA from approximately 100° to <20°, indicating the presence of a significant amount of hydrophilic C-OH groups on the surface.

### Surface modification

For surface modification of thus activated COC, trihydro-F17 was used. 2 µl of hydrosilane (30% solution) was deposited on the surface, which was then covered by the photomask and irradiated for 10 minutes. After rinsing, samples were vacuum dried before being analyzed.

### Results

After surface modification, the irradiated part of the sample had a WCA of 90°, while the non-irradiated part had a WCA of 46°. These values suggest that a photochemical surface modification of COC has taken place. The increased WCA in the non-irradiated part indicates that beside photochemical surface modification, some other reaction also takes place. This is confirmed by XPS analysis, which shows the presence of fluorine on both the irradiated and the non-irradiated side of the sample. However, the amount of fluorine on the irradiated area is more than twice as high. Therefore, the results demonstrate that hydrosilanes can be used for photochemical surface modification of COC.

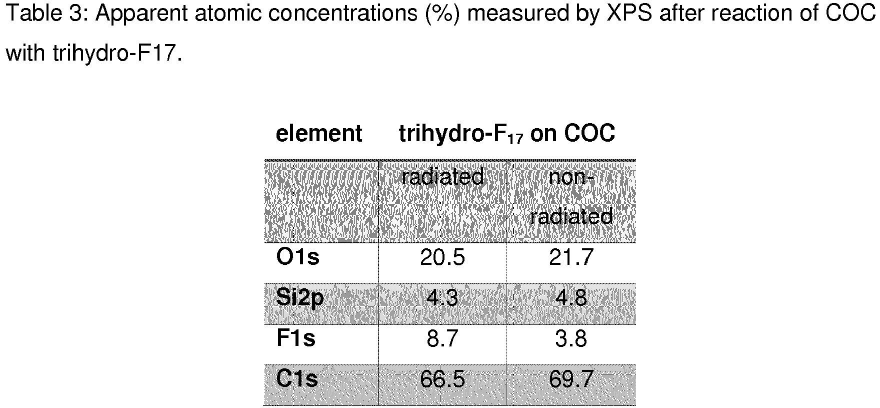

### 2.2 Cellulose

### Sample preparation

Pieces of cellulose blotting paper were cleaned by sonication in dichloromethane and vacuum dried.

### Surface modification

For surface modification of cellulose, trihydro-F17 was used. 50 µl of hydrosilane (30% solution) was deposited on the surface, which was then covered by the photomask and irradiated for 30 minutes. After rinsing, samples were dried with Ar before being analyzed.

### Results

After surface modification, the irradiated side of the sample had a WCA of approximately 120°. On the non-irradiated area, WCA could not be measured, since the droplet sinks into the hydrophilic porous paper. This result indicates that hydrosilanes can be used for photochemical surface modification of cellulose.

### 3 Results - Surface modification of epoxide surfaces with hydrosilanes

### 3.1 Epoxysilane

### Sample preparation

To prepare surfaces with epoxide groups, glass microscope slides were treated with an epoxysilane according to a silanization procedure adapted from literature. Samples were cleaned by ultrasonicating in acetone for 5 minutes. Samples were dried using a stream of nitrogen and subsequently placed in an oven at 140 °C for 5 minutes. Then, samples were exposed to a low pressure O₂ plasma for 5 minutes and immediately immersed in a 2% (v/v) solution of (3-glycidyloxypropyl)trimethoxysilane in hexane for 2 hours. After silanization, samples were cleaned by 5 minutes ultrasonication in acetone and drying in a stream of nitrogen. After this silanization procedure, the epoxide-terminated surfaces have a WCA of 55°.

### Surface modification

In one experiment, surface modification of epoxide-terminated surfaces was done by depositing trihydro-F17 on the surface, covering the sample with the photomask and irradiating it for 30 minutes. In another experiment, a mixture of dihydro-F17 (95% v/v) and F17-acrylate (5% v/v) was used for surface modification, using an irradiation time of 30 minutes. After irradiation, samples were cleaned by rinsing and ultrasonication in trifluorotoluene and dichloromethane, followed by drying in a stream of nitrogen.

### Results

After surface modification with trihydro-F17, the irradiated area of the sample has a WCA of 110°, while the WCA on the non-irradiated side remains unchanged at 55°. XPS analysis shows the presence of a large amount of fluorine (17 atom%) on the irradiated area, while on the non-irradiated area no detectable amount of fluorine is present. After surface modification with the dihydro-F17/F17-acrylate mixture, the irradiated area of the sample has a WCA of 114°, while the WCA on the non-irradiates side remains unchanged at 55°. These results indicate that a photochemical reaction of the hydrosilanes with the epoxide groups on the surface has taken place on the irradiated area, while no reaction has taken place on the non-irradiated area.

### 3.2 SU-8

### Sample preparation

SU-8 is a negative photoresist containing many epoxide groups. After curing of SU-8, a number of residual epoxide groups will be present on the surface of the material. Therefore, SU-8 surfaces were used for surface modification with hydrosilanes without any pretreatment.

### Surface modification

A mixture of dihydro-F17 (99% v/v) and F17-acrylate (1 % v/v) was deposited on the SU-8 surface, covered with a quartz slide and irradiated for 30 minutes. The sample was then rinsed and sonicated in trifluorotoluene and dichloromethane and dried in a stream of nitrogen.

### Results

Before surface modification, the WCA of the SU-8 surface is 79o. After surface modification, the WCA of the sample increased to 95o. This result indicates that hydrosilanes can be used for the photochemical surface modification of SU-8.

## Claims

1. A process for the modification of a surface of a solid material, comprising the step of contacting the surface with a surface-modifying compound under irradiation with light of a wavelength in the range of 200 to 800 nm optionally in the presence of a photoinitiator, wherein
a) the surface has Si-OH groups, C-OH or epoxy groups and the surface-modifying compound is a hydrosilane, or
b) the surface has O-Si-H groups and the surface-modifying compound is a silanol or an alcohol.

2. The process according to claim 1, wherein the surface has Si-OH groups or C-OH groups and the surface-modifying compound is a hydrosilane.

3. The process according to any one of the preceding claims, wherein a predetermined part of the surface is selectively subjected to the irradiation.

4. The process according to any one of the preceding claims, wherein the irradiation is performed in the absence of a photoinitiator and the light has a wavelength in the range of 200 nm to 300 nm, preferably 260 nm to 300 nm, more preferably 280 to 300 nm.

5. The process according to any one of the preceding claims, wherein the process comprises the step of treating the surface to have micro- and/or nanoscale surface roughness before the irradiation step.

6. The process according to any one of the preceding claims, wherein the surface-modifying compound is contacted with the surface in the form of a surface-modifying compound composition comprising the surface-modifying compound and one or more of a photoinitiator, a solvent, a compound that is reactive towards the surface-modifying compound and micro and/or nanoparticles.

7. The process according to any one of the preceding claims, wherein the surface-modifying compound is contacted with the surface in the form of a surface-modifying compound composition comprising the surface-modifying compound and a compound that is reactive towards the surface-modifying compound, wherein the amount of the compound that is reactive towards the surface-modifying compound in the surface-modifying compound composition is 50-99.9 vol%, for example 60-95 vol% or 70-90 vol%, of the surface-modifying compound composition.

8. The process according to any one of claims 1-7, wherein the process involves a) and the surface has Si-OH groups and the solid material is preferably selected from the group consisting of silica, glass, oxidized silicon, oxidized silicon nitride and oxidized silicon carbide and a polymer provided on the surface with a film of one of the foregoing materials.

9. The process according to any one of claims 1-7, wherein the process involves a) and the surface has C-OH groups and the solid material is preferably selected from the group consisting of polysaccharides, paper, poly(vinyl alcohol), etched silicon carbide, oxidized diamond, oxidized graphite, oxidized graphene and oxidized polymers.

10. The process according to any one of claims 1-9, wherein the process involves a) and the hydrosilane is represented by 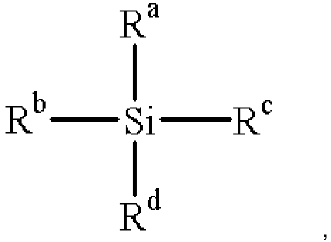
wherein at least one of R^{a}, R^{b}, R^{c}, and R^{d} is H and at least one of R^{a}, R^{b}, R^{c}, and R^{d} is not H,
where each of R^{a}, R^{b}, R^{c}, and R^{d} is, independently, H, linear C₁₋₃₀ alkyl, branched C₁₋₃₀ alkyl, cyclic C₃₋₃₀ alkyl, linear C₂₋₃₀ alkenyl, branched C₂₋₃₀ alkenyl, linear C₂₋₃₀ alkynyl, branched C₂₋₃₀ alkynyl, C₆₋₂₀ aralkyl, C₆₋₁₀ aryl, or a polymeric moiety having a molecular weight of about 1000 to about 100,000,
wherein the polymeric moiety is selected from the group consisting of hydrocarbon polymers, polyesters, polyamides, polyethers, polyacrylates, polyurethanes, epoxies, polymethacrylates and polysiloxanes,
wherein each of R^{a}, R^{b}, R^{c}, and R^{d} is optionally substituted with one or more substituents selected from the group consisting of -F, -Cl, -Br, -CN, -NO₂, =O, -N=C=O, -N=C=S, 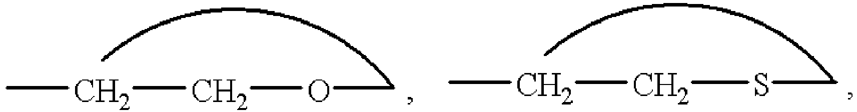 -N₃, -NR^{e}R^{f}, -SR^{g}, -OR^{h}, -CO₂Rⁱ, -PR^{j}R^{k}R^{l}, -P(OR^{m}) (ORⁿ) (OR^{p}),-P(=O) (OR^{q}) (OR⁸), -P (=O)₂OR^{t}, -OP(=O)₂OR^{u}, -S(=O)₂R^{v}, -S(=O)R^{w},-S(=O)₂OR^{x}, -C(=O)NR^{y}R^{z}, and -OSiR^{aa}R^{bb}R^{cc},
wherein each of R^{e}, R^{f}, R^{g}, R^{h}, Rⁱ, R^{j}, R^{k}, R^{l}, R^{m}, Rⁿ, R^{p}, R^{q}, R^{s}, R^{t}, R^{u}, R^{v}, R^{w}, R^{x}, R^{y}, and R^{z}, is, independently, H, linear C₁₋₁₀alkyl, branched C₁₋₁₀alkyl, cyclic C₃₋₈alkyl, linear C₂₋₁₀alkenyl, branched C₂₋₁₀alkenyl, linear C₂₋₁₀alkynyl, branched C₂₋₁₀alkynyl, C₆₋₁₂aralkyl, or C₆₋₁₀aryl, and is optionally substituted with one or more substituents selected from the group consisting of -F, -Cl, and -Br,
wherein each of R^{aa},R^{bb}, and R^{cc} is, independently, linear C₁₋₁₀alkyl, branched C₁₋₁₀alkyl, cyclic C₃₋₈alkyl, linear C₂₋₁₀alkenyl, branched C₂₋₁₀alkenyl, linear C₂₋₁₀, alkynyl, branched C₂₋₁₀alkynyl, C₆₋₁₂aralkyl, C₆₋₁₀aryl, -F, -Cl, -Br, or OR^{dd}, where R^{dd} is linear C₁₋₁₀alkyl or branched C₁₋₁₀alkyl.

11. The process according to claim 9, wherein one or two of R^{a}, R^{b}, R^{c}, and R^{d} is H, preferably two of R^{a}, R^{b}, R^{c}, and R^{d} is H.

12. The process according to any one of claims 1-7, wherein the process involves b) and the solid material is hydrogen-terminated glass (H-glass), polymer modified to have a surface having O-Si-H groups or poly(methylhydrosiloxane)

13. The process according to any one of claims 1-7 and 12, wherein the process involves b) and the surface-modifying compound is represented by
HO-Si-R¹R²R³
wherein at least one of R¹, R², R³ is not H,
where each of R¹, R² and R³ is, independently,
H, linear C₁₋₃₀ alkyl, branched C₁₋₃₀ alkyl, cyclic C₃₋₃₀ alkyl, linear C₂₋₃₀ alkenyl, branched C₂₋₃₀ alkenyl, linear C₂₋₃₀alkynyl, branched C₂₋₃₀alkynyl, C₆₋₂₀ aralkyl, C₆₋₁₀ aryl, or a polymeric moiety having a molecular weight of about 1000 to about 100,000,
wherein the polymeric moiety is selected from the group consisting of hydrocarbon polymers, polyesters, polyamides, polyethers, polyacrylates, polyurethanes, epoxies, polymethacrylates and polysiloxanes,
wherein each of R^{a}, R^{b}, R^{c}, and R^{d} is optionally substituted with one or more substituents selected from the group consisting of -F, -Cl, -Br, -CN, -NO₂, =O, -N=C=O, -N=C=S, 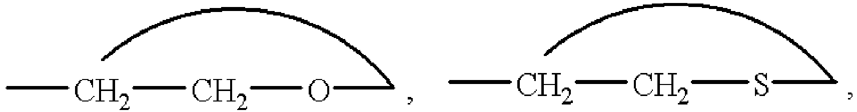 -N₃, -NR^{e}R^{f}, -SR^{g}, -OR^{h}, -CO₂Rⁱ, -PR^{j}R^{k}R^{l}, -P(OR^{m}) (ORⁿ) (OR^{p}),-P(=O) (OR^{q}) (OR⁸), -P (=O)₂OR^{t}, -OP(=O)₂OR^{u}, -S(=O)₂R^{v}, -S(=O)R^{w},-S(=O)₂OR^{x}, -C(=O)NR^{y}R^{z}, and -OSiR^{aa}R^{bb}R^{cc},
wherein each of R^{e}, R^{f}, R^{g}, R^{h}, Rⁱ, R^{j}, R^{k}, R^{l}, R^{m}, Rⁿ, R^{p}, R^{q}, R^{s}, R^{t}, R^{u}, R^{v}, R^{w}, R^{x}, R^{y}, and R^{z}, is, independently, H, linear C₁₋₁₀alkyl, branched C₁₋₁₀alkyl, cyclic C₃₋₈alkyl, linear C₂₋₁₀alkenyl, branched C₂₋₁₀alkenyl, linear C₂₋₁₀alkynyl, branched C₂₋₁₀alkynyl, C₆₋₁₂aralkyl, or C₆₋₁₀aryl, and is optionally substituted with one or more substituents selected from the group consisting of -F, -Cl, and -Br,
wherein each of R^{aa},R^{bb}, and R^{cc} is, independently, linear C₁₋₁₀alkyl, branched C₁₋₁₀alkyl, cyclic C₃₋₈alkyl, linear C₂₋₁₀alkenyl, branched C₂₋₁₀alkenyl, linear C₂₋₁₀, alkynyl, branched C₂₋₁₀alkynyl, C₆₋₁₂aralkyl, C₆₋₁₀aryl, -F, -Cl, -Br, or OR^{dd}, where R^{dd} is linear C₁₋₁₀alkyl or branched C₁₋₁₀alkyl, or
HO-C-R⁴R⁵R⁶,
wherein at least one of R⁴, R⁵, R⁶ is not H,
where each of R⁴, R⁵, R⁶ is, independently, H, linear C₁₋₃₀ alkyl, branched C₁₋₃₀ alkyl, cyclic C₃₋₃₀ alkyl, linear C₂₋₃₀ alkenyl, branched C₂₋₃₀ alkenyl, linear C₂₋₃₀alkynyl, branched C₂₋₃₀alkynyl, C₆₋₂₀ aralkyl, C₆₋₁₀ aryl, or a polymeric moiety having a molecular weight of about 1000 to about 100,000,
wherein the polymeric moiety is selected from the group consisting of hydrocarbon polymers, polyesters, polyamides, polyethers, polyacrylates, polyurethanes, epoxies, polymethacrylates and polysiloxanes,
wherein each of R^{a}, R^{b}, R^{c}, and R^{d} is optionally substituted with one or more substituents selected from the group consisting of -F, -Cl, -Br, -CN, -NO₂, =O, -N=C=O, -N=C=S, 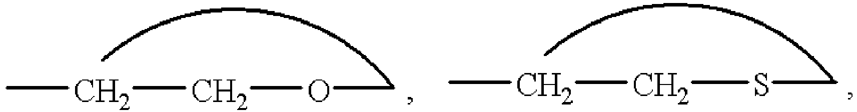 -N₃, -NR^{e}R^{f}, -SR^{g}, -OR^{h}, -CO₂Rⁱ, -PR^{j}R^{k}R^{l}, -P(OR^{m}) (ORⁿ) (OR^{p}),-P(=O) (OR^{q}) (OR⁸), -P (=O)₂OR^{t}, -OP(=O)₂OR^{u}, -S(=O)₂R^{v}, -S(=O)R^{w},-S(=O)₂OR^{x}, -C(=O)NR^{y}R^{z}, and -OSiR^{aa}R^{bb}R^{cc},
wherein each of R^{e}, R^{f}, R^{g}, R^{h}, Rⁱ, R^{j}, R^{k}, R^{l}, R^{m}, Rⁿ, R^{p}, R^{q}, R^{s}, R^{t}, R^{u}, R^{v}, R^{w}, R^{x}, R^{y}, and R^{z}, is, independently, H, linear C₁₋₁₀ alkyl, branched C₁₋₁₀ alkyl, cyclic C₃₋₈ alkyl, linear C₂₋₁₀ alkenyl, branched C₂₋₁₀ alkenyl, linear C₂₋₁₀ alkynyl, branched C₂₋₁₀ alkynyl, C₆₋₁₂aralkyl, or C₆₋₁₀ aryl, and is optionally substituted with one or more substituents selected from the group consisting of -F, -Cl, and -Br,
wherein each of R^{aa},R^{bb}, and R^{cc} is, independently, linear C₁₋₁₀ alkyl, branched C₁₋₁₀alkyl, cyclic C₃₋₈ alkyl, linear C₂₋₁₀ alkenyl, branched C₂₋₁₀ alkenyl, linear C₂₋₁₀, alkynyl, branched C₂₋₁₀ alkynyl, C₆₋₁₂ aralkyl, C₆₋₁₀ aryl, -F, -Cl, -Br, or OR^{dd}, where R^{dd} is linear C₁₋₁₀ alkyl or branched C₁₋₁₀ alkyl.

14. An article comprising the surface-modified solid material obtainable by the process according to any one of claims 1-13, wherein the article has micro- or nanostructures.

15. The article according to claim 14, wherein the article is selected from the group consisting of a substrate for biochip applications such as microarray applications and cell culture applications; a microfluidic device such as a lab-on-a-chip device and an organ-on-a-chip device.

## Patentansprüche

1. Verfahren zur Modifikation einer Oberfläche eines festen Materials, umfassend den Schritt des Inkontaktbringens der Oberfläche mit einer oberflächenmodifizierenden Verbindung unter Bestrahlung mit Licht mit einer Wellenlänge im Bereich von 200 bis 800 nm gegebenenfalls in Gegenwart eines Photoinitiators, wobei
a) die Oberfläche Si-OH Gruppen, C-OH- oder Epoxygruppen aufweist und die oberflächenmodifizierende Verbindung ein Hydrosilan ist, oder
b) die Oberfläche O-Si-H-Gruppen aufweist und die oberflächenmodifizierende Verbindung ein Silanol oder ein Alkohol ist.

2. Verfahren nach Anspruch 1, wobei die Oberfläche Si-OH-Gruppen oder C-OH-Gruppen aufweist und die oberflächenmodifizierende Verbindung ein Hydrosilan ist.

3. Verfahren nach einem der vorstehenden Ansprüche, wobei ein vorbestimmter Teil der Oberfläche selektiv der Bestrahlung unterzogen wird.

4. Verfahren nach einem der vorstehenden Ansprüche, wobei die Bestrahlung in Abwesenheit eines Photoinitiators durchgeführt wird und das Licht eine Wellenlänge im Bereich von 200 nm bis 300 nm, vorzugsweise 260 nm bis 300 nm, mehr bevorzugt 280 bis 300 nm, aufweist.

5. Verfahren nach einem der vorstehenden Ansprüche, wobei das Verfahren vor dem Bestrahlungsschritt den Schritt des Behandelns der Oberfläche derart, dass sie eine mikro- und/oder nanoskalige Oberflächenrauheit aufweist, umfasst.

6. Verfahren nach einem der vorstehenden Ansprüche, wobei die oberflächenmodifizierende Verbindung mit der Oberfläche in Form einer oberflächenmodifizierenden Verbindungszusammensetzung in Kontakt gebracht wird, die die oberflächenmodifizierende Verbindung und einen oder mehrere von einem Photoinitiator, einem Lösungsmittel, einer Verbindung, die gegenüber der oberflächenmodifizierenden Verbindung reaktiv ist, und Mikro- und/oder Nanoteilchen umfasst.

7. Verfahren nach einem der vorstehenden Ansprüche, wobei die oberflächenmodifizierende Verbindung mit der Oberfläche in Form einer oberflächenmodifizierenden Verbindungszusammensetzung in Kontakt gebracht wird, die die oberflächenmodifizierende Verbindung und eine Verbindung umfasst, die gegenüber der oberflächenmodifizierenden Verbindung reaktiv ist, wobei die Menge der Verbindung, die gegenüber der oberflächenmodifizierenden Verbindung reaktiv ist, in der oberflächenmodifizierenden Verbindungszusammensetzung 50 - 99,9 Vol.- %, zum Beispiel 60 - 95 Vol.- % oder 70 - 90 Vol.- %, der oberflächenmodifizierenden Verbindung, beträgt.

8. Verfahren nach einem der Ansprüche 1 - 7, wobei das Verfahren a) beinhaltet und die Oberfläche Si-OH-Gruppen aufweist und das feste Material vorzugsweise ausgewählt ist aus der Gruppe bestehend aus Siliciumdioxid, Glas, oxidiertem Silicium, oxidiertem Siliciumnitrid und oxidiertem Siliciumcarbid und einem Polymer, das auf der Oberfläche mit einem Film aus einem der vorstehenden Materialien versehen ist.

9. Verfahren nach einem der Ansprüche 1 - 7, wobei das Verfahren a) beinhaltet und die Oberfläche C-OH-Gruppen aufweist und das feste Material vorzugsweise ausgewählt ist aus der Gruppe bestehend aus Polysacchariden, Papier, Poly(vinylalkohol), geätztem Siliciumcarbid, oxidiertem Diamant, oxidiertem Graphit, oxidiertem Graphen und oxidierten Polymeren.

10. Verfahren nach einem der Ansprüche 1 - 9, wobei das Verfahren a) beinhaltet und das Hydrosilan dargestellt ist durch 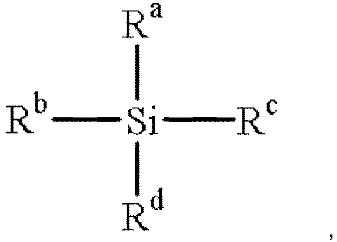
wobei mindestens eines von R^{a}, R^{b}, R^{c} und R^{d} H ist und mindestens eines von R^{a}, R^{b}, R^{c} und R^{d} nicht H ist,
wobei jedes von R^{a}, R^{b}, R^{c} und R^{d} unabhängig
H, lineares C₁₋₃₀-Alkyl, verzweigtes C₁₋₃₀-Alkyl, cyclisches C₃₋₃₀-Alkyl, lineares C₂₋₃₀-Alkenyl, verzweigtes C₂₋₃₀-Alkenyl, lineares C₂₋₃₀-Alkinyl, verzweigtes C₂₋₃₀-Alkinyl,C₆₋₂₀-Aralkyl, C₆₋₁₀-Aryl oder eine Polymereinheit mit einem Molekulargewicht von etwa 1000 bis etwa 100.000 ist,
wobei die Polymereinheit ausgewählt ist aus der Gruppe bestehend aus Kohlenwasserstoffpolymeren, Polyestern, Polyamiden, Polyethern, Polyacrylaten, Polyurethanen, Epoxiden, Polymethacrylaten und Polysiloxanen,
wobei jedes von R^{a}, R^{b}, R^{c} und R^{d} gegebenenfalls mit einem oder mehreren Substituenten substituiert ist, die ausgewählt sind aus der Gruppe bestehend aus -F, -Cl, -Br, -CN, -NO₂, =O, - N=C=O, -N=C=S, 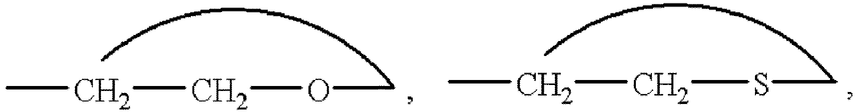 -N₃, -NR^{e}R^{f}, -SR^{g}, -OR^{h}, -CO₂Rⁱ, -PR^{j}R^{k}R^{l}, -P(OR^{m}) (ORⁿ) (OR^{p}), -P(=O) (OR^{q}) (OR⁸), -P (=O)₂OR^{t}, OP(=O)₂OR^{u}, -S(=O)₂R^{v},-S(=O)R^{w}, -S(=O)₂OR^{x}, - C(=O)NR^{y}R^{z} und -OSiR^{aa}R^{bb}R^{cc},
wobei jedes von R^{e}, R^{f}, R^{g}, R^{h}, Rⁱ, R^{j}, R^{k}, R^{l}, R^{m}, Rⁿ, R^{p}, R^{q}, R^{s}, R^{t}, R^{u}, R^{v}, R^{w}, R^{x}, R^{y} und R^{z} unabhängig H, lineares C₁₋₁₀-Alkyl, verzweigtes C₁₋₁₀-Alkyl, cyclisches C₃₋₈-Alkyl, lineares C₂₋₁₀-Alkenyl, verzweigtes C₂₋₁₀-Alkenyl, lineares C₂₋₁₀-Alkinyl, verzweigtes C₂₋₁₀-Alkinyl, C₆₋₁₂-Aralkyl oder C₆₋₁₀-Aryl ist und gegebenenfalls mit einem oder mehreren Substituenten substituiert ist, die ausgewählt sind aus der Gruppe bestehend aus -F, -Cl und -Br, wobei jedes von R^{aa}, R^{bb} und R^{cc} unabhängig lineares C₁₋₁₀-Alkyl, verzweigtes C₁₋₁₀-Alkyl, cyclisches C₃₋₈-Alkyl, lineares C₂₋₁₀-Alkenyl, verzweigtes C₂₋₁₀-Alkenyl, lineares C₂₋₁₀-Alkinyl, verzweigtes C₂₋₁₀-Alkinyl, C₆₋₁₂-Aralkyl, C₆₋₁₀-Aryl, -F, -Cl, -Br oder OR^{dd} ist, wobei R^{dd} lineares C₁₋₁₀-Alkyl oder verzweigtes C₁₋₁₀-Alkyl ist.

11. Verfahren nach Anspruch 9, wobei ein oder zwei von R^{a}, R^{b}, R^{c} und R^{d} H sind, vorzugsweise zwei von R^{a}, R^{b}, R^{c} und R^{d} H sind.

12. Verfahren nach einem der Ansprüche 1 - 7, wobei das Verfahren b) beinhaltet und das feste Material wasserstoffterminiertes Glas (H-Glas) ist, wobei das Polymer derart modifiziert ist, dass es eine Oberfläche mit O-Si-H-Gruppen oder Poly(methylhydrosiloxan) aufweist.

13. Verfahren nach einem der Ansprüche 1 - 7 und 12, wobei das Verfahren b) beinhaltet und die oberflächenmodifizierende Verbindung dargestellt ist durch
HO-Si-R¹R²R³
wobei mindestens eines von R¹, R² R³ nicht H ist,
wobei jedes von R¹, R² und R³ unabhängig
H, lineares C₁₋₃₀-Alkyl, verzweigtes C₁₋₃₀-Alkyl, cyclisches C₃₋₃₀-Alkyl, lineares C₂₋₃₀-Alkenyl, verzweigtes C₂₋₃₀-Alkenyl, lineares C₂₋₃₀-Alkinyl, verzweigtes C₂₋₃₀-Alkinyl,C₆₋₂₀-Aralkyl, C₆₋₁₀-Aryl oder eine Polymereinheit mit einem Molekulargewicht von etwa 1000 bis etwa 100.000 ist,
wobei die Polymereinheit ausgewählt ist aus der Gruppe bestehend aus Kohlenwasserstoffpolymeren, Polyestern, Polyamiden, Polyethern, Polyacrylaten, Polyurethanen, Epoxiden, Polymethacrylaten und Polysiloxanen,
wobei jedes von R^{a}, R^{b}, R^{c} und R^{d} gegebenenfalls mit einem oder mehreren Substituenten substituiert ist, die ausgewählt sind aus der Gruppe bestehend aus -F, -Cl, -Br, -CN, -NO₂, =O, -N=C=O, -N=C=S, 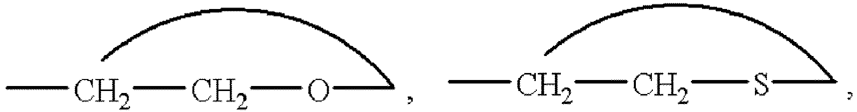 -N₃, -NR^{e}R^{f}, -SR^{g}, -OR^{h}, -CO₂Rⁱ, - PR^{j}R^{k}R^{l}, -P(OR^{m}) (ORⁿ) (OR^{p}), -P(=O) (OR^{q}) (OR⁸), -P (=O)₂OR^{t}, -OP(=O)₂OR^{u}, -S(=O)₂R^{v},-S(=O)R^{w}, -S(=O)₂OR^{x}, - C(=O)NR^{y}R^{z} und -OSiR^{aa}R^{bb}R^{cc},
wobei jedes von R^{e}, R^{f}, R^{g}, R^{h}, Rⁱ, R^{j}, R^{k}, R^{l}, R^{m}, R^{u}, R^{p}, R^{q}, R^{s}, R^{t}, R^{u}, R^{v}, R^{w}, R^{x}, R^{y} und R^{z} unabhängig H, lineares C₁₋₁₀-Alkyl, verzweigtes C₁₋₁₀-Alkyl, cyclisches C₃₋₈-Alkyl, lineares C₂₋₁₀-Alkenyl, verzweigtes C₂₋₁₀-Alkenyl, lineares C₂₋₁₀-Alkinyl, verzweigtes C₂₋₁₀-Alkinyl, C₆₋₁₂-Aralkyl oder C₆₋₁₀-Aryl ist und gegebenenfalls mit einem oder mehreren Substituenten substituiert ist, die ausgewählt sind aus der Gruppe bestehend aus -F, -Cl und -Br,
wobei jedes von R^{aa}, R^{bb} und R^{cc} unabhängig lineares C₁₋₁₀-Alkyl, verzweigtes C₁₋₁₀-Alkyl, cyclisches C₃₋₈-Alkyl, lineares C₂₋₁₀-Alkenyl, verzweigtes C₂₋₁₀-Alkenyl, lineares C₂₋₁₀-Alkinyl, verzweigtes C₂₋₁₀-Alkinyl, C₆₋₁₂-Aralkyl, C₆₋₁₀-Aryl, -F, -Cl, -Br oder OR^{dd} ist, wobei R^{dd} lineares C₁₋₁₀-Alkyl oder verzweigtes C₁₋₁₀-Alkyl oder
HO-C-R⁴R⁵R⁶ ist,
wobei mindestens eines von R⁴, R⁵, R⁶ nicht H ist,
wobei jedes von R⁴, R⁵, R⁶ unabhängig
H, lineares C₁₋₃₀-Alkyl, verzweigtes C₁₋₃₀-Alkyl, cyclisches C₃₋₃₀-Alkyl, lineares C₂₋₃₀-Alkenyl, verzweigtes C₂₋₃₀-Alkenyl, lineares C₂₋₃₀-Alkinyl, verzweigtes C₂₋₃₀-Alkinyl,C₆₋₂₀-Aralkyl, C₆₋₁₀-Aryl oder eine Polymereinheit mit einem Molekulargewicht von etwa 1000 bis etwa 100.000 ist,
wobei die Polymereinheit ausgewählt ist aus der Gruppe bestehend aus Kohlenwasserstoffpolymeren, Polyestern, Polyamiden, Polyethern, Polyacrylaten, Polyurethanen, Epoxiden, Polymethacrylaten und Polysiloxanen,
wobei jedes von R^{a}, R^{b}, R^{c} und R^{d} gegebenenfalls mit einem oder mehreren Substituenten substituiert ist, die ausgewählt sind aus der Gruppe bestehend aus -F, -Cl, -Br, -CN, -NO₂, =O, - N=C=O, -N=C=S, 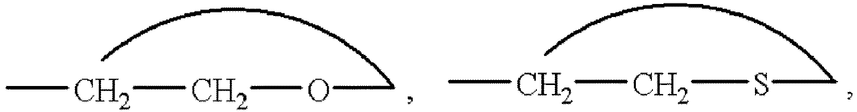 -N₃, -NR^{e}R^{f}, -SR^{g}, -OR^{h}, -CO₂Rⁱ, - PR^{j}R^{k}R^{l}, -P(OR^{m}) (ORⁿ) (OR^{p}), - P(=O) (OR^{q}) (OR⁸), -P (=O)₂OR^{t} -OP(=O)₂OR^{u}, -S(=O)₂R^{v}, -S(=O)R^{w}, - S(=O)₂OR^{x}, - C(=O)NR^{y}R^{z} und -OSiR^{aa}R^{bb}R^{cc},
wobei jedes von R^{e}, R^{f}, R^{g}, R^{h}, Rⁱ, R^{j}, R^{k}, R^{l}, R^{m}, R^{u}, R^{p}, R^{q}, R^{s}, R^{t}, R^{u}, R^{v}, R^{w}, R^{x}, R^{y} und R^{z} unabhängig H, lineares C₁₋₁₀-Alkyl, verzweigtes C₁₋₁₀-Alkyl, cyclisches C₃₋₈-Alkyl, lineares C₂₋₁₀-Alkenyl, verzweigtes C₂₋₁₀-Alkenyl, lineares C₂₋₁₀-Alkinyl, verzweigtes C₂₋₁₀-Alkinyl, C₆₋₁₂-Aralkyl oder C₆₋₁₀-Aryl ist und gegebenenfalls mit einem oder mehreren Substituenten substituiert ist, die ausgewählt sind aus der Gruppe bestehend aus -F, -Cl und -Br,
wobei jedes von R^{aa}, R^{bb} und R^{cc} unabhängig lineares C₁₋₁₀-Alkyl, verzweigtes C₁₋₁₀-Alkyl, cyclisches C₃₋₈-Alkyl, lineares C₂₋₁₀-Alkenyl, verzweigtes C₂₋₁₀-Alkenyl, lineares C₂₋₁₀-Alkinyl, verzweigtes C₂₋₁₀-Alkinyl, C₆₋₁₂-Aralkyl, C₆₋₁₀-Aryl, -F, -Cl,-Br oder OR^{dd} ist, wobei R^{dd} lineares C₁₋₁₀-Alkyl oder verzweigtes C₁₋₁₀-Alkyl ist.

14. Artikel, umfassend das oberflächenmodifizierte feste Material, das durch das Verfahren nach einem der Ansprüche 1 - 13 erhältlich ist, wobei der Artikel Mikro- oder Nanostrukturen aufweist.

15. Artikel nach Anspruch 14, wobei der Artikel ausgewählt ist aus der Gruppe bestehend aus einem Substrat für Biochip-Anwendungen wie Microarray-Anwendungen und Zellkulturanwendungen; einer mikrofluidischen Vorrichtung wie einer Lab-on-a-Chip-Vorrichtung und einer Organ-on-a-Chip-Vorrichtung.

## Revendications

1. Procédé pour la modification d'une surface d'un matériau solide, comprenant l'étape de mise en contact de la surface avec un composé de modification de surface sous irradiation avec de la lumière d'une longueur d'onde dans la plage de 200 à 800 nm facultativement en présence d'un photoinitiateur, dans lequel
a) la surface a des groupes Si-OH, des groupes C-OH ou époxy et le composé de modification de surface est un hydrosilane, ou
b) la surface a des groupes O-Si-H et le composé de modification de surface est un silanol ou un alcool.

2. Procédé selon la revendication 1, dans lequel la surface a des groupes Si-OH ou des groupes C-OH et le composé de modification de surface est un hydrosilane.

3. Procédé selon l'une quelconque des revendications précédentes, dans lequel une partie prédéterminée de la surface est soumise sélectivement à l'irradiation.

4. Procédé selon l'une quelconque des revendications précédentes, dans lequel l'irradiation est mise en œuvre en l'absence d'un photoinitiateur et la lumière a une longueur d'onde dans la plage de 200 nm à 300 nm, de préférence 260 nm à 300 nm, plus préférablement 280 à 300 nm.

5. Procédé selon l'une quelconque des revendications précédentes, dans lequel le procédé comprend l'étape de traitement de la surface pour avoir une rugosité de surface à l'échelle micro- et/ou nanométrique avant l'étape d'irradiation.

6. Procédé selon l'une quelconque des revendications précédentes, dans lequel le composé de modification de surface est mis en contact avec la surface sous la forme d'une composition de composé de modification de surface comprenant le composé de modification de surface et un ou plusieurs parmi un photoinitiateur, un solvant, un composé qui est réactif vis-à-vis du composé de modification de surface et des micro et/ou nanoparticules.

7. Procédé selon l'une quelconque des revendications précédentes, dans lequel le composé de modification de surface est mis en contact avec la surface sous la forme d'une composition de composé de modification de surface comprenant le composé de modification de surface et un composé qui est réactif vis-à-vis du composé de modification de surface, dans lequel la quantité du composé qui est réactif vis-à-vis du composé de modification de surface dans la composition de composé de modification de surface va de 50 à 99,9 % en volume, par exemple 60 à 95 % en volume ou 70 à 90 % en volume, de la composition de composé de modification de surface.

8. Procédé selon l'une quelconque des revendications 1 à 7, dans lequel le procédé implique a) et la surface a des groupes Si-OH et le matériau solide est de préférence choisi dans le groupe constitué de silice, verre, silicium oxydé, nitrure de silicium oxydé et carbure de silicium oxydé et un polymère pourvu sur la surface d'un film d'un des matériaux qui précèdent.

9. Procédé selon l'une quelconque des revendications 1 à 7, dans lequel le procédé implique a) et la surface a des groupes C-OH et le matériau solide est de préférence choisi dans le groupe constitué de polysaccharides, papier, alcool polyvinylique, carbure de silicium attaqué, diamant oxydé, graphite oxydé, graphène oxydé et polymères oxydés.

10. Procédé selon l'une quelconque des revendications 1 à 9, dans lequel le procédé implique a) et l'hydrosilane est représenté par 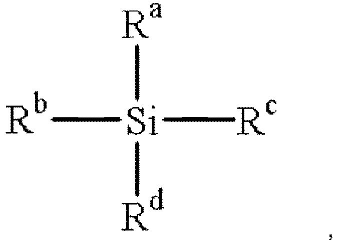
dans lequel au moins un de R^{a}, R^{b}, R^{c}, et R^{d} est H et au moins un de R^{a}, R^{b}, R^{c}, et R^{d} n'est pas H,
où chacun de R^{a}, R^{b}, R^{c}, et R^{d} est, indépendamment,
H, alkyle en C_{1 à 30} linéaire, alkyle en C_{1 à 30} ramifié, alkyle en C_{3 à 30} cyclique, alcényle en C_{2 à 30} linéaire, alcényle en C_{2 à 30} ramifié, alcynyle en C_{2 à 30} linéaire, alcynyle en C_{2 à 30} ramifié, aralkyle en C_{6 à 20}, aryle en C_{6 à 10}, ou un fragment polymère ayant une masse moléculaire d'environ 1000 à environ 100 000,
dans lequel le fragment polymère est choisi dans le groupe constitué de polymères d'hydrocarbure, polyesters, polyamides, polyéthers, polyacrylates, polyuréthanes, époxys, polyméthacrylates et polysiloxanes,
dans lequel chacun de R^{a}, R^{b}, R^{c}, et R^{d} est facultativement substitué par un ou plusieurs substituants choisis dans le groupe constitué de -F, -Cl, -Br, -CN, -NO₂, =O, -N=C=O, -N=C=S, 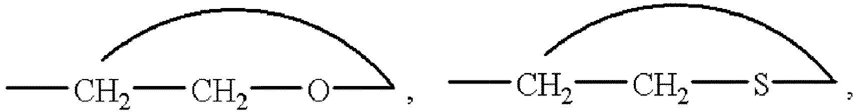 -N₃, -NR^{e}R^{f}, -SR^{g}, -OR^{h}, -CO₂Rⁱ, -PR^{j}R^{k}R^{l}, -P(OR^{m}) (ORⁿ) (OR^{p}), -P(=O) (OR^{q}) (OR^{S}), -P (=O)₂OR^{t}, -OP(=O)₂OR^{u}, -S(=O)₂R^{v}, - S(=O)R^{w}, -S(=O)₂OR^{x}, - C(=O)NR^{y}R^{z}, et -OSiR^{aa}R^{bb}R^{cc},
dans lequel chacun de R^{e}, R^{f}, R^{g}, R^{h}, Rⁱ, R^{j}, R^{k}, R^{l}, R^{m}, Rⁿ, R^{p}, R^{q}, R^{s}, R^{t}, R^{u}, R^{v}, R^{w}, R^{x}, R^{y}, et R^{z}, est, indépendamment, H, alkyle en C_{1 à 10} linéaire, alkyle en C_{1 à 10} ramifié, alkyle en C_{3 à 8} cyclique, alcényle en C_{2 à 10} linéaire, alcényle en C_{2 à 10} ramifié, alcynyle en C_{2 à 10} linéaire, alcynyle en C_{2 à 10} ramifié, aralkyle en C_{6 à 12} ramifié, ou aryle en C_{6 à 10}, et est facultativement substitué par un ou plusieurs substituants choisis dans le groupe constitué de -F, -Cl, et -Br, dans lequel chacun de R^{aa}, R^{bb}, et R^{cc} est, indépendamment, alkyle en C_{1 à 10} linéaire, alkyle en C_{1 à 10} ramifié, alkyle en C_{3 à 8} cyclique, alcényle en C_{2 à 10} linéaire, alcényle en C_{2 à 10} ramifié, alcynyle en C_{2 à 10} linéaire, alcynyle en C_{2 à 10} ramifié, aralkyle en C_{6 à 12}, aryle en C_{6 à 10}, -F, -Cl, -Br, ou OR^{dd}, où R^{dd} est alkyle en C_{1 à 10} linéaire ou alkyle en C_{1 à 10} ramifié.

11. Procédé selon la revendication 9, dans lequel un ou deux de R^{a}, R^{b}, R^{c}, et R^{d} sont H, de préférence deux de R^{a}, R^{b}, R^{c}, et R^{d} sont H.

12. Procédé selon l'une quelconque des revendications 1 à 7, dans lequel le procédé implique b) et le matériau solide est du verre à terminaison hydrogène (verre H), un polymère modifié pour avoir une surface ayant des groupes O-Si-H ou du poly(méthylhydrosiloxane)

13. Procédé selon l'une quelconque des revendications 1 à 7 et 12, dans lequel le procédé implique b) et le composé de modification de surface est représenté par
HO-Si-R¹R²R³
dans lequel au moins un de R¹, R², R³ n'est pas H,
où chacun de R¹, R² et R³ est, indépendamment,
H, alkyle en C_{1 à 30} linéaire, alkyle en C_{1 à 30} ramifié, alkyle en C_{3 à 30} cyclique, alcényle en C_{2 à 30} linéaire, alcényle en C_{2 à 30} ramifié, alcynyle en C_{2 à 30} linéaire, alcynyle en C_{2 à 30} ramifié, aralkyle en C_{6 à 20}, aryle en C_{6 à 10}, ou un fragment polymère ayant une masse moléculaire d'environ 1000 à environ 100 000,
dans lequel le fragment polymère est choisi dans le groupe constitué de polymères d'hydrocarbure, polyesters, polyamides, polyéthers, polyacrylates, polyuréthanes, époxys, polyméthacrylates et polysiloxanes,
dans lequel chacun de R^{a}, R^{b}, R^{c}, et R^{d} est facultativement substitué par un ou plusieurs substituants choisis dans le groupe constitué de -F, -Cl, -Br, -CN, -NO₂, =O, -N=C=O, -N=C=S, 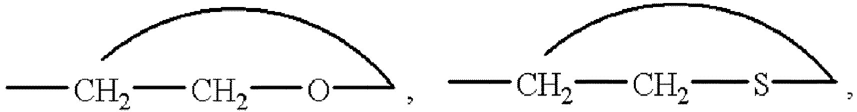 -N₃, -NR^{e}R^{f}, -SR^{g}, -OR^{h}, -CO₂Rⁱ, -PR^{j}R^{k}R^{l}, -P(OR^{m}) (ORⁿ) (OR^{p}), -P(=O) (OR^{q}) (OR⁸), -P (=O)₂OR^{t}, -OP(=O)₂OR^{u}, -S(=O)₂R^{v},-S(=O)R^{w}, -S(=O)₂OR^{x}, - C(=O)NR^{y}R^{z}, et -OSiR^{aa}R^{bb}R^{cc},
dans lequel chacun de R^{e}, R^{f}, R^{g}, R^{h}, Rⁱ, R^{j}, R^{k}, R^{l}, R^{m}, Rⁿ, R^{p}, R^{q}, R^{s}, R^{t}, R^{u}, R^{v}, R^{w}, R^{x}, R^{y}, et R^{z}, est, indépendamment, H, alkyle en C_{1 à 10} linéaire, alkyle en C_{1 à 10} ramifié, alkyle en C_{3 à 8} cyclique, alcényle en C_{2 à 10} linéaire, alcényle en C_{2 à 10} ramifié, alcényle en C_{2 à 10} linéaire, alcynyle en C_{2 à 10} ramifié, aralkyle en C_{6 à 12}, ou aryle en C_{6 à 10}, et est facultativement substitué par un ou plusieurs substituants choisis dans le groupe constitué de -F, -Cl, et -Br,
dans lequel chacun de R^{aa}, R^{bb}, et R^{cc} est, indépendamment, alkyle en C_{1 à 10} linéaire, alkyle en C_{1 à 10} ramifié, alkyle en C_{3 à 8} cyclique, alcényle en C_{2 à 10} linéaire, alcényle en C_{2 à 10} ramifié, alcynyle en C_{2 à 10} linéaire, alcynyle en C_{2 à 10} ramifié, aralkyle en C_{6 à 12}, aryle en C_{6 à 10}, -F, -Cl, -Br, ou OR^{dd}, où R^{dd} est alkyle en C_{1 à 10} linéaire ou alkyle en C_{1 à 10} ramifié ou
HO-C-R⁴R⁵R⁶,
dans lequel au moins un de R⁴, R⁵, R⁶ n'est pas H,
où chacun de R⁴, R⁵, R⁶ est, indépendamment,
H, alkyle en C_{1 à 30} linéaire, alkyle en C_{1 à 30} ramifié, alkyle en C_{3 à 30} cyclique, alcényle en C_{2 à 30} linéaire, alcényle en C_{2 à 30} ramifié, alcynyle en C_{2 à 30} linéaire, alcynyle en C_{2 à 30} ramifié, aralkyle en C_{6 à 20}, aryle en C_{6 à 10}, ou un fragment polymère ayant une masse moléculaire d'environ 1000 à environ 100 000,
dans lequel le fragment polymère est choisi dans le groupe constitué de polymères d'hydrocarbure, polyesters, polyamides, polyéthers, polyacrylates, polyuréthanes, époxys, polyméthacrylates et polysiloxanes,
dans lequel chacun de R^{a}, R^{b}, R^{c}, et R^{d} est facultativement substitué par un ou plusieurs substituants choisis dans le groupe constitué de -F, -Cl, -Br, -CN, -NO₂, =O, -N=C=O, -N=C=S, 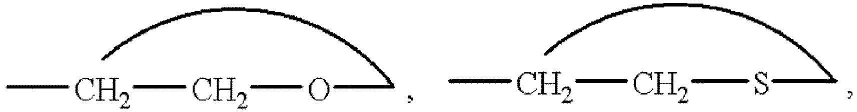 -N₃, -NR^{e}R^{f}, -SR^{g}, -OR^{h}, -CO₂Rⁱ, -PR^{j}R^{k}R^{l}, -P(OR^{m}) (ORⁿ) (OR^{P}), -P(=O) (OR^{q}) (OR⁸), -P (=O)₂OR^{t}, -OP(=O)₂OR^{u}, -S(=O)₂R^{v}, - S(=O)R^{w}, -S(=O)₂OR^{x}, - C(=O)NR^{y}R^{z}, et -OSiR^{aa}R^{bb}R^{cc},
dans lequel chacun de R^{e}, R^{f}, R^{g}, R^{h}, Rⁱ, R^{j}, R^{k}, R^{l}, R^{m}, Rⁿ, R^{p}, R^{q}, R^{s}, R^{t}, R^{u}, R^{v}, R^{w}, R^{x}, R^{y}, et R^{z}, est, indépendamment, H, alkyle en C_{1 à 10} linéaire, alkyle en C_{1 à 10} ramifié, alkyle en C_{3 à 8} cyclique, alcényle en C_{2 à 10} linéaire, alcényle en C_{2 à 10} ramifié, alcényle en C_{2 à 10} linéaire, alcynyle en C_{2 à 10} ramifié, aralkyle en C_{6 à 12}, ou aryle en C_{6 à 10}, et est facultativement substitué par un ou plusieurs substituants choisis dans le groupe constitué de -F, -Cl, et -Br,
dans lequel chacun de R^{aa}, R^{bb}, et R^{cc} est, indépendamment, alkyle en C_{1 à 10} linéaire, alkyle en C_{1 à 10} ramifié, alkyle en C_{3 à 8} cyclique, alcényle en C_{2 à 10} linéaire, alcényle en C_{2 à 10} ramifié, alcynyle en C_{2 à 10} linéaire, alcynyle en C_{2 à 10} ramifié, aralkyle en C_{6 à 12}, aryle en C_{6 à 10}, -F, -Cl, -Br, ou OR^{dd}, où R^{dd} est alkyle en C_{1 à 10} linéaire ou alkyle en C_{1 à 10} ramifié.

14. Article comprenant le matériau solide modifié en surface pouvant être obtenu par le procédé selon l'une quelconque des revendications 1 à 13, dans lequel l'article a des micro- ou nanostructures.

15. Article selon la revendication 14, dans lequel l'article est choisi dans le groupe constitué d'un substrat pour des applications de biopuce telles que des applications de micromatrice et des applications de culture cellulaire ; un dispositif microfluidique tel qu'un dispositif de laboratoire sur puce et un dispositif d'organe sur puce.
